(19) Europäisches Patentamt / European Patent Office / Office européen des brevets

(11) **EP 2 376 931 B1**

(12) **EUROPÄISCHE PATENTSCHRIFT**

(45) Veröffentlichungstag und Bekanntmachung des Hinweises auf die Patenterteilung:
**13.03.2019 Patentblatt 2019/11**

(21) Anmeldenummer: **10708696.9**

(22) Anmeldetag: **15.01.2010**

(51) Int Cl.:
*H04B 3/462* (2015.01)          *G01R 23/20* (2006.01)
*G01R 27/28* (2006.01)

(86) Internationale Anmeldenummer:
**PCT/EP2010/000218**

(87) Internationale Veröffentlichungsnummer:
**WO 2010/081725 (22.07.2010 Gazette 2010/29)**

(54) **VERFAHREN UND NETZWERKANALYSATOR ZUR MESSUNG DER GRUPPENLAUFZEIT IN EINEM MESSOBJEKT**

METHOD AND DEVICE FOR MEASURING GROUP DELAY CAUSED BY A DEVICE UNDER TEST

PROCÉDÉ ET DISPOSITIF DE MESURE DU TEMPS DE PROPAGATION DE GROUPE CAUSÉ PAR UN DISPOSITIF SOUMIS A UN ESSAI

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität:
**15.01.2009 DE 102009004727**
**09.04.2009 DE 102009017032**
**29.07.2009 DE 102009035179**

(43) Veröffentlichungstag der Anmeldung:
**19.10.2011 Patentblatt 2011/42**

(73) Patentinhaber: **Rohde & Schwarz GmbH & Co. KG**
**81671 München (DE)**

(72) Erfinder:
• **BEDNORZ, Thilo**
  **85435 Erding (DE)**
• **NEIDHARDT, Steffen**
  **08485 Lengenfeld (DE)**

(74) Vertreter: **Körfer, Thomas**
**Mitscherlich PartmbB**
**Patent- und Rechtsanwälte**
**Sonnenstrasse 33**
**80331 München (DE)**

(56) Entgegenhaltungen:
**EP-A1- 0 293 883     EP-A1- 1 515 147**
**US-A- 6 046 595     US-A1- 2003 233 599**
**US-B1- 6 529 844**

• **EBERSBERGER G ET AL: "TELEVISION SIGNAL DISTORTION IN SURFACE-WAVE FILTERS AND ITS MEASUREMENT" EBU REVIEW- TECHNICAL, EUROPEAN BROADCASTING UNION. BRUSSELS, BE, Nr. 221, 1. Februar 1987 (1987-02-01), Seiten 21-30, XP000068793 ISSN: 0251-0936**
• **ADRIAN JONES ET AL: "Measurement of Group Delay using the 6840 series Microwave System Analyzer with Option 22" APPLICATION NOTE IFR, XX, XX, Bd. a, 1. Januar 2000 (2000-01-01), Seiten 1-12, XP002279331**

**Beschreibung**

Die Erfindung betrifft ein Verfahren und einen Netzwerkanalysator zur Messung der Gruppenlaufzeit in einem Messobjekt.

Für viele Anwendungsfelder ist das lineare Übertragungsverhalten einer elektronischen Komponente zu ermitteln. Neben der Verzerrung der Amplitude interessiert hierbei auch die Phasenverzerrung der zu messenden elektronischen Komponente. Wird das Messobjekt - deviceunder-test (DUT) - mit einem hochfrequenten Anregungssignal angeregt, so kann es im Messobjekt zu einer Phasenverzögerung und damit zu einer zeitlichen Verzögerung, der sogenannten Gruppenlaufzeit, kommen. Die Gruppenlaufzeit $\tau_G$, die im folgenden interessiert, ergibt sich gemäß Gleichung (1) aus der Änderungsrate der Phase $\Delta\varphi$ in Abhängigkeit der Frequenz $\Delta f$.

$$\tau_G = \frac{-1}{360°} \cdot \frac{\Delta\varphi}{\Delta f} \qquad\qquad (1)$$

Problematisch bei einer Gruppenlaufzeitmessung ist insbesondere der Einfluss zusätzlicher, direkt nicht eliminierbarer Einflussfaktoren innerhalb des Messobjekts auf die Gruppenlaufzeit, die die Qualität des Messergebnisses verschlechtern. Hierzu zählen hauptsächlich die phasenverzerrenden Wirkungen von Zu- und Ableitungen des Messobjekts oder im Fall eines frequenzkonvertierenden Messobjekts der Einfluss einer unbekannten, eventuell sogar driftenden Oszillator-Frequenz eines lokalen Oszillators in einem Mischer auf dessen zu ermittelnde Gruppenlaufzeit.

Aus der EP 1 515 147 A1 ist ein Verfahren zur Bestimmung der Gruppenlaufzeit in einer elektronischen Komponente bekannt, die derartige unbekannte Einflüsse auf die Gruppenlaufzeit des Messobjekts kompensiert. Hierbei wird das Messobjekt mit einem amplitudenmodulierten Anregungssignal angeregt, das aus der Modulation eines als Dirac-Kamm realisierten Trägers mit einem rein sinusförmigen Modulationssignal hervorgeht. Das bei Anregung des Messobjekts mit einem derartigen Anregungssignal am Messobjekt mit einem TransientenRekorder periodisch über jeweils konstante Zeitintervalle gemessene Antwortsignal wird in einem Spektrum-Analysator mittels Fast-Fourier-Transformation in den Spektralbereich transformiert. Von den beiden am unteren und oberen Seitenband des amplitudenmodulierten Antwortsignals an den einzelnen Trägerfrequenzen des Dirac-Kamms jeweils gelegenen Spektrallinien des phasenverzerrten Antwortsignals werden die Phasen ermittelt. Die Gruppenlaufzeit bei einer bestimmten Trägerfrequenz ergibt sich aus der Differenz der gemessenen Phasen der am oberen und unteren Seitenband bei der jeweiligen Trägerfrequenz gelegenen Spektrallinien des Antwortsignals abzüglich der doppelten Phase des Modulationssignals - entspricht der Phasendifferenz der am oberen und unteren Seitenband derselben Trägerfrequenz gelegenen Spektrallinien des zugehörigen Anregungssignals - und normiert mit dem bekannten Frequenzabstand zwischen oberen und unteren Seitenband des amplitudenmodulierten Anregungs- bzw. Antwortsignals.

Bei den in den Figuren 1 und 3 der EP 0 293 883 A1 dargestellten Ausführungsformen werden jeweils das Anregungssignal und das zugehörige vom Messobjekt bei Anregung durch das Anregungssignal erzeugte Antwortsignal gleichzeitig einem Phasendetektor zur Ermittlung der Phasendifferenz zugeführt.

Bei der in der US 6,046,595 A beschriebenen Gruppenlaufzeit-Messung werden ebenfalls das Anregungssignal und das zugehörige Antwortsignal zur Ermittlung der Phasenantwort eines Meßobjekts gleichzeitig in einem Prozessor zur Ermittlung der Phasenantwort eingelesen und miteinander verarbeitet.

Die US 6,529,844 B1 offenbart einen vektoriellen Netzwerkanalysator zur Messung von S-Parametern eines Meßobjekts. Die Messung der von einem Meßobjekt erzeugten Gruppenlaufzeit mittels Messung des Vorwärtsübertragungsfaktors S21 des Meßobjekts erfolgt in einem vektoriellen Netzwerkanalysator, wie schematisch in Fig. 2 dieser Druckschrift dargestellt ist, durch gleichzeitige Messung des Anregungssignals und des Antwortsignals.

In der US 2003/0233599 A1 wird im Kalibrierung-Modus einzig das Anregungssignal erfasst und weiterverarbeitet. Im Mess-Modus wird das Anregungssignal und das durch das Messobjekt gegenüber dem Anregungssignal verzögerte Antwortsignal gleichzeitig erfasst und weiterverarbeitet.

Die Bestimmung der Gruppenlaufzeit eines Messobjekts gemäß der EP 1 515 147 A1 weist nachteilig eine Vielzahl von Laborgeräten - Signalgenerator, Transientenrekorder, Spektrum-Analysator, Synchronisiervorrichtung - auf und benötigt zur Kompensation der unbekannten Phase des Modulationssignals eine zusätzliche Kalibriermessung bei einer Referenzträgerfrequenz. Insbesondere ist die Erzeugung des Dirac-Kamms aufwendig.

Aufgabe der Erfindung ist es deshalb, ein System und Verfahren mit minimalen geräte- und verfahrenstechnischen Aufwand zur Bestimmung der Gruppenlaufzeit eines Messobjekts zu entwickeln, das die Kompensation unbekannter, negativer messobjektinterner Einflussfaktoren auf die Gruppenlaufzeit ermöglicht.

Die Erfindungsaufgabe wird durch ein Verfahren zur Messung einer Gruppenlaufzeit mit den Merkmalen des Patentanspruchs 1 und durch einen Netzwerkanalysator mit den Merkmalen des Patentanspruchs 16 gelöst. Vorteile technische Erweiterungen sind in den jeweils abhängigen Patentansprüchen aufgeführt.

Zur Reduzierung des geräte- und verfahrenstechnischen Aufwands wird erfindungsgemäß ein Netzwerkanalysator verwendet, der die Möglichkeit aufweist, ein harmonisches Zweitonsignal - zwei sinusförmige Signale in einem bestimmten Frequenzabstand - als Anregungssignal zu erzeugen und dieses Anregungssignal einerseits über einen ersten Anschluss dem Messobjekt zur Anregung - auf das DUT zulaufende Welle $a_1$ - und andererseits einem Referenzkanal zur Signalauswertung zuzuführen. Zugleich wird das vom Messobjekt bei Anregung mit dem Anregungssignal verursachte Antwortsignal - vom DUT zurücklaufende Welle $b_2$ - über einen zweiten Anschluss einem Messkanal des Netzwerkanalysators zugeführt.

Getrennt werden die beiden sinusförmigen Signale des Anregungssignals in einer ersten Ausführungsform des erfindungsgemäßen Systems im Referenzkanal über jeweils eine Mischereinheit und die beiden sinusförmigen Signale des Antwortsignals im Messkanal über jeweils eine Mischereinheit in ein zugehöriges Basisbandsignal gemischt und über jeweils eine Detektions-Einheit die zum jeweiligen Basisbandsignal gehörige Phase synchron zum gleichen Zeitpunkt erfasst. Die Gruppenlaufzeit wird in einer Berechnungseinheit aus der Phasendifferenz der beiden zum Antwortsignal gehörigen Basisbandsignale abzüglich der Phasendifferenz der beiden zum Anregungssignal gehörigen Basisbandsignale und durch anschließende Division durch den Frequenzabstand der beiden harmonischen Signale des Anregungs- bzw. Antwortsignals gewonnen. Die Bestimmung der Gruppenlaufzeit entspricht folglich einer Phasenbestimmung des Vorwärtsübertragungsfaktors $S_{21}$ des Messobjekts

$$S_{21} = \left.\frac{b_2}{a_1}\right|_{a_2=0}$$

und einer anschließenden Normierung mit dem Frequenzabstand der beiden Signale des Anregungs- bzw. Antwortsignals.

Durch die erfindungsgemäße Messung der Phasendifferenz der zum Anregungs- und gleichzeitig zum Antwortsignal jeweils gehörigen Signale kann auf eine zusätzliche zeitaufwendige Kaliebriermessung verzichtet werden. Der gerätetechnische Aufwand reduziert sich darüber hinaus erfindungsgemäß einzig auf einen Netzwerkanalysator. Wie in der Beschreibung der mathematischen Grundlagen des erfindungsgemäßen Verfahrens weiter unten gezeigt wird, wird die unbekannte Oszillator-Frequenz des im zu vermessenden Mischer enthaltenen lokalen Oszillators kompensiert und hat somit keinen Einfluss auf das Ergebnis der zu ermittelnden Gruppenlaufzeit des Mischers.

Um die Mischung des Anregungs- und des Antwortsignals ins Basisband digital realisieren zu können, wird das hochfrequente Anregungs- und Antwortsignal unter Zwischenschaltung jeweils eines zusätzlichen Mischers im Referenz- und Messkanal ins Zwischenfrequenzband gemischt und von jeweils einem nachfolgenden Analog-Digital-Wandler digitalisiert. Um Eindeutigkeit in der Signalauswertung zu erzielen, werden z.B. einzig die vom jeweiligen zusätzlichen Mischer generierten unteren Seitenbandsignale der beiden zum Anregungs- bzw. Antwortsignal gehörigen Signale weiterverwendet, indem die jeweiligen oberen Seitenbandsignale mittels Filterung im Referenz- bzw. Messkanal beseitigt werden. Natürlich kann auch umgekehrt vorgegangen werden.

Die Generierung des als Zweitonsignal realisierten Anregungssignals erfolgt über zwei Signalquellen, welche die beiden Signale des Anregungssignals jeweils erzeugen. Die Zusammenführung der beiden Signale zum Anregungssignal erfolgt entweder über einen Hochfrequenzkoppler oder über einen Mischer im Sinne einer Amplitudenmodulation. Analog kann das Zweiton-Anregungssignal auch über eine Frequenz- oder Pulsmodulation eines Sinusträgers generiert werden. Optional kann der Signalgenerator auch außerhalb des Netzwerkanalysators realisiert sein.

In einer zweiten Ausführungsform des erfindungsgemäßen Systems werden die beiden sinusförmigen Signale des Anregungssignals im Referenzkanal und die beiden sinusförmigen Signale des Antwortsignals im Messkanal jeweils nach einer Mischung ins Basisband oder alternativ ins Zwischenfrequenzband und einer Analog-Digital-Wandlung gemeinsam jeweils einem Fast-Fourier-Transformator zugeführt, in dem die Phasen der beiden ins Basis- oder Zwischenfrequenzband gemischten Spektrallinien des Anregungssignals bzw. des Antwortsignals ermittelt und einer Berechnungs-Einheit zur Ermittlung der Gruppenlaufzeit zugeführt werden.

In einer dritten Ausführungsform des erfindungsgemäßen Systems erfolgt die Mischung und Messung der beiden sinusförmigen Signale des Anregungssignals und der beiden sinusförmigen Signale des Antwortsignals ins Zwischenfrequenzband jeweils sequentiell, indem die zugehörigen Mischer jeweils sequentiell über eine Steuerung von einem gemeinsamen lokalen Oszillator angesteuert werden. Die in der Umschaltphase des gemeinsamen lokalen Oszillators zwischen referenzkanalseitigen zum messkanalseitigen Mischer stattfindende Phasenänderung zwischen den benötigten Trägern des Anregungs- bzw. Antwortsignals wird durch die im selben Umfang stattfindende Phasenänderung der beiden lokalen Oszillatorsignale kompensiert, die jeweils dem im Referenz- und Messkanal positionierten Basisband-Mischer phasenkohärent zugeführt werden.

In einer vierten Ausführungsform des erfindungsgemäßen Systems, in der ebenfalls eine sequentielle Zwischenfrequenzband-Mischung der beiden sinusförmigen Signale des Anregungssignals und der beiden sinusförmigen Signale des Antwortsignals durch ein gemeinsames lokales Oszillatorsignal erfolgt, wird die Phasenänderung des Anregungs- bzw. des Antwortsignals in der Umschaltphase durch eine Umschaltung eines gemeinsamen lokalen Oszillatorsignals zwischen referenzkanal- und messkanalseitigen Basisbandmischer kompensiert, die zur Umschaltung des gemeinsamen lokalen Oszillatorsignals zwischen referenzkanal- und messkanalseitigen Zwischenfrequenzband-Mischer synchron abläuft.

In einer fünften Ausführungsform des erfindungsgemäßen Systems wird nur noch ein einziger gemeinsamer Messkanal verwendet, der wie der Mess- bzw. Referenzkanal der ersten Ausführungsform der Erfindung ausgeführt ist. Über eine Empfängersteuerung werden die beiden sinusförmigen Signale des Anregungssignals sequentiell zu den beiden sinusförmigen Signalen des Antwortsignals auf den gemeinsamen Messkanal geführt.

In einer sechsten Ausführungsform des erfindungsgemäßen Systems ist der einzige gemeinsame Messkanal wie der Mess- bzw. der Referenzkanal in der zweiten Ausführungsform der Erfindung ausgeführt.

Durch Integration der somit ermittelten Gruppenlaufzeit über die Frequenz kann eine Phase als Funktion der Frequenz gewonnen werden, die aufgrund der unbekannten Integrationskonstante nicht eindeutig ermittelbar ist. Wird für diese i.a. nichtlinear von der Frequenz abhängige Phase eine Linearisierung durch Bestimmung einer zugehörigen linearen Regressionsgerade durchgeführt, so kann durch Differenzbildung der nichtlinearen Phase von der lineare Phase eine relative Phase ermittelt werden, die die Nichteindeutigkeit der ursprünglich durch Integration ermittelten Phase aufgrund der unbekannten Integrationskonstante nicht aufweist.

Im Folgenden werden die Ausführungsformen des erfindungsgemäßen Verfahrens und Systems zur Messung der Gruppenlaufzeit eines Messobjekts mit einem Netzwerkanalysator im Detail anhand der Zeichnung erläutert. Die Figuren der Zeichnung zeigen:

Fig. 1A    ein Blockschaltbild einer ersten Ausführungsform des erfindungsgemäßen Systems zur Messung der Gruppenlaufzeit eines Messobjekts mit einem Netzwerkanalysator,

Fig. 1B    ein Blockschaltbild einer zweiten Ausführungsform des erfindungsgemäßen Systems zur Messung der Gruppenlaufzeit eines Messobjekts mit einem Netzwerkanalysator,

Fig. 1C    ein Blockschaltbild einer dritten Ausführungsform des erfindungsgemäßen Systems zur Messung der Gruppenlaufzeit eines Messobjekts mit einem Netzwerkanalysator,

Fig. 1D    ein Blockschaltbild einer vierten Ausführungsform des erfindungsgemäßen Systems zur Messung der Gruppenlaufzeit eines Messobjekts mit einem Netzwerkanalysator,

Fig. 1E    ein Blockschaltbild einer fünften Ausführungsform des erfindungsgemäßen Systems zur Messung der Gruppenlaufzeit eines Messobjekts mit einem Netzwerkanalysator,

Fig. 1F    ein Blockschaltbild einer sechsten Ausführungsform des erfindungsgemäßen Systems zur Messung der Gruppenlaufzeit eines Messobjekts mit einem Netzwerkanalysator,

Fig. 2A    ein Flussdiagramm einer ersten Ausführungsform des erfindungsgemäßen Verfahrens zur Messung der Gruppenlaufzeit eines Messobjekts mit einem Netzwerkanalysator und

Fig. 2B    ein Flussdiagramm einer zweiten Ausführungsform des erfindungsgemäßen Verfahrens zur Messung der Gruppenlaufzeit eines Messobjekts mit einem Netzwerkanalysator.

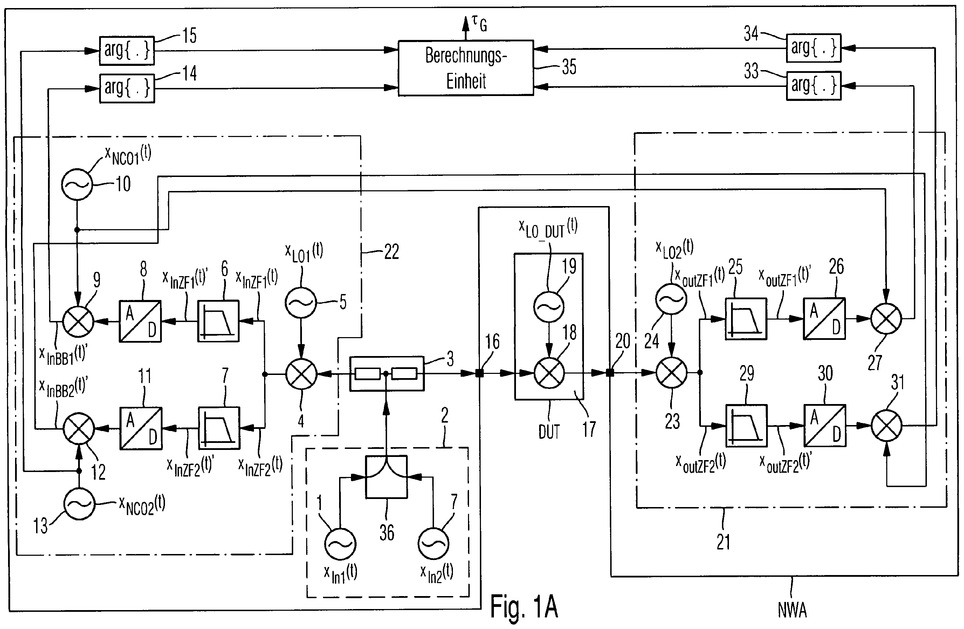

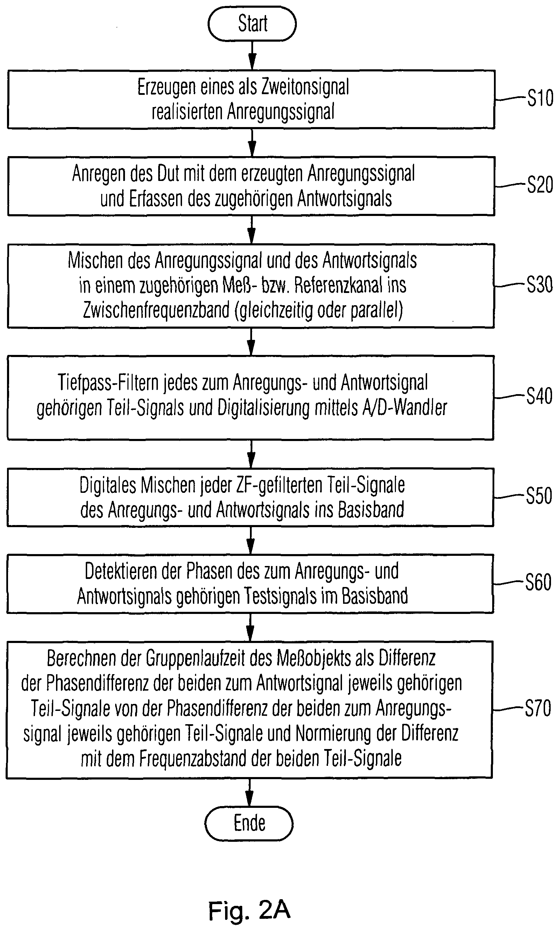

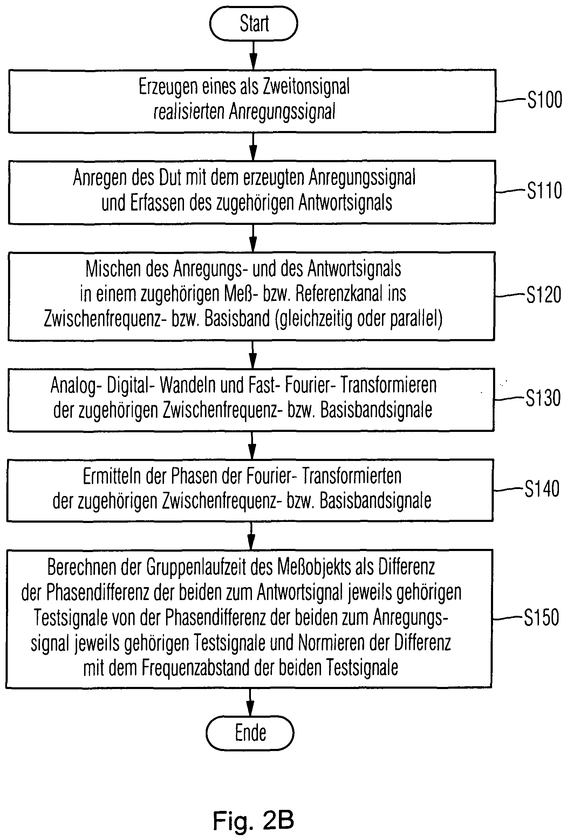

Bevor die beiden Ausführungsformen des erfindungsgemäßen Verfahrens zur Messung der Gruppenlaufzeit $\tau_G$ eines Messobjekts mit einem Netzwerkanalysator (NWA) anhand der Figuren 2A und 2B beschrieben werden, werden vorerst die für das Verständnis der Erfindung erforderlichen mathematischen Grundlagen unter zur Hilfenahme der in den Figuren 1A bis 1F dargestellten Ausführungsformen des erfindungsgemäßen Systems zur Messung der Gruppenlaufzeit $\tau_G$ eines Messobjekts mit einem Netzwerkanalysator (NWA) hergeleitet:

Das in einer ersten Signalquelle 1 der Signalgenerator-Einheit 2 erzeugte Signal $x_{In1}(t)$ des Anregungssignals $x_{In}(t)$, das ein hochfrequentes Eintonsignal $x_{InHF1}(t)$, d.h. ein hochfrequentes rein sinusförmiges Signal $x_{InHF1}(t)$, darstellt, wird gemäß Fig. 1A nach einer Signalaufsplittung in einem Signalverteiler 3 entsprechend der ersten Ausführungsform der Erfindung in einem ersten Mischer 4 mithilfe eines von einem lokalen Oszillator 5 erzeugten Trägersignals $x_{Lo1}(t)$ gemäß Gleichung (2) in ein korrespondierendes Zwischenfrequenzsignal $x_{InZF1}(t)$ gemischt. Nach einer Anti-Aliasing-Filterung gemäß Gleichung (3) in einem Tiefpass-Filter 6, dessen Grenzfrequenz zwischen der Frequenz $\omega_{Lo1}-\omega_{In1}$ des unteren Seitenbands und der Frequenz $\omega_{Lo1}+\omega_{In1}$ des oberen Seitenbands des entstandenen Mischerprodukts liegt, wird ein korrespondierendes Zwischenfrequenzsignal $x_{InZF1}(t)'$ mit einem Signal im unteren Seitenband des Mischerprodukts erzeugt.

$$x_{InZF1}(t) = x_{InHF1}(t) \cdot x_{Lo1}(t) = e^{-j(\omega_{In1} \cdot t + \varphi_{In1})} \cdot e^{-j(\omega_{Lo1} \cdot t + \varphi_{Lo1})} \qquad (2)$$

$$x_{InZF1}(t)' = e^{-j((\omega_{Lo1} - \omega_{In1}) \cdot t + \varphi_{Lo1} - \varphi_{In1})} \qquad (3)$$

In Gleichung (2) bzw. (3) werden wie in allen folgenden Gleichungen die Amplituden der Signale zur Vereinfachung der realen Signalzusammenhänge ohne Beschränkung der Allgemeinheit auf den Wert 1 normiert. Anstelle des unteren Seitenbands des Mischerprodukts kann alternativ auch das obere Seitenband des Mischerprodukts verwendet werden und ist von der Erfindung mit abgedeckt.

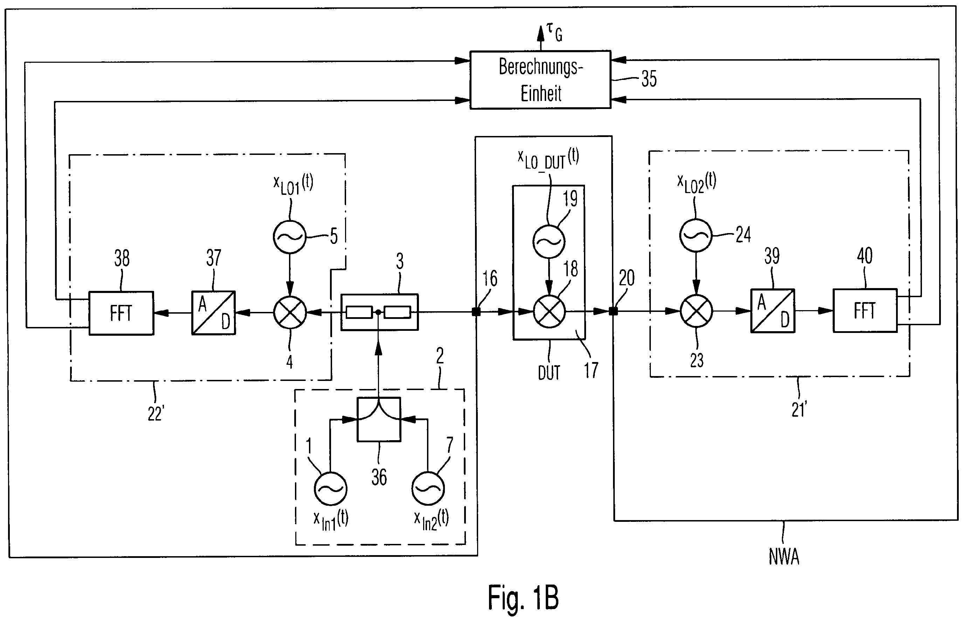

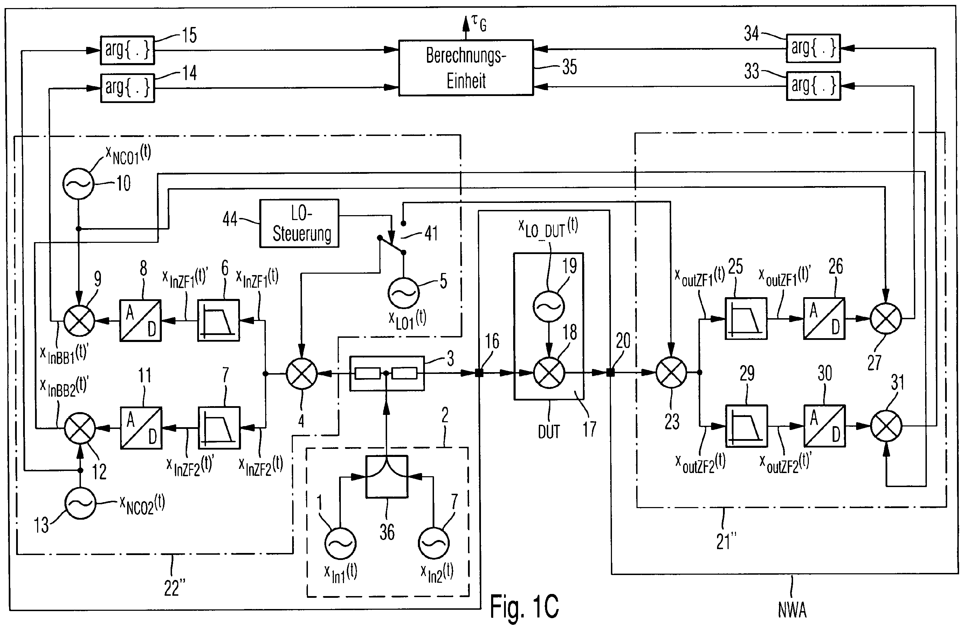

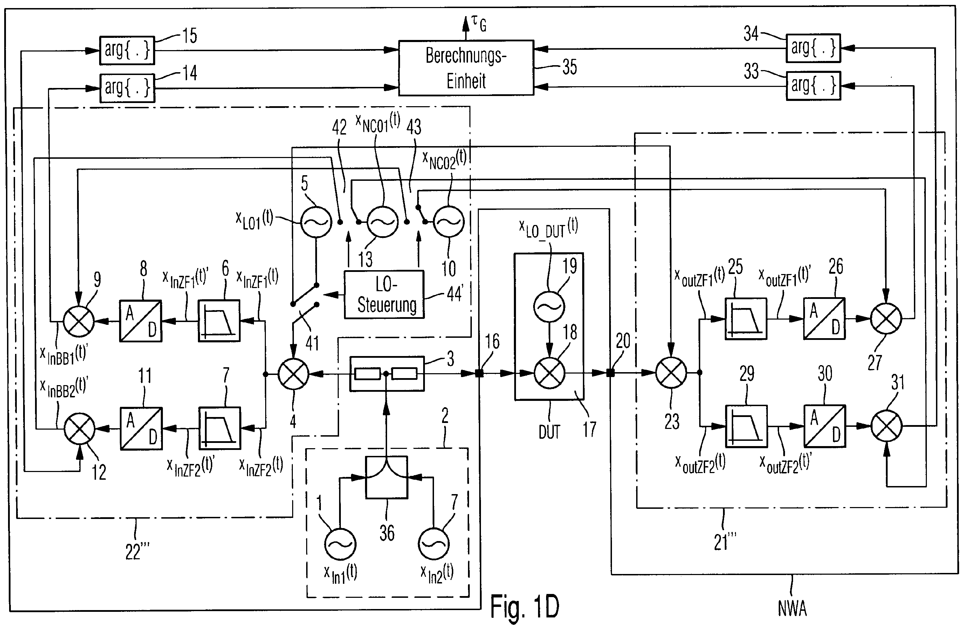

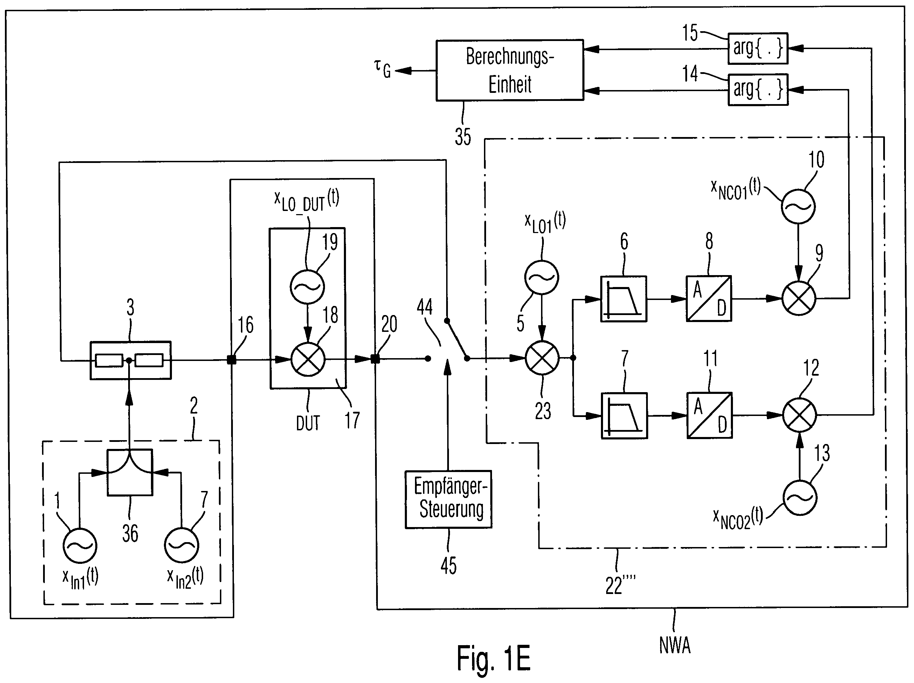

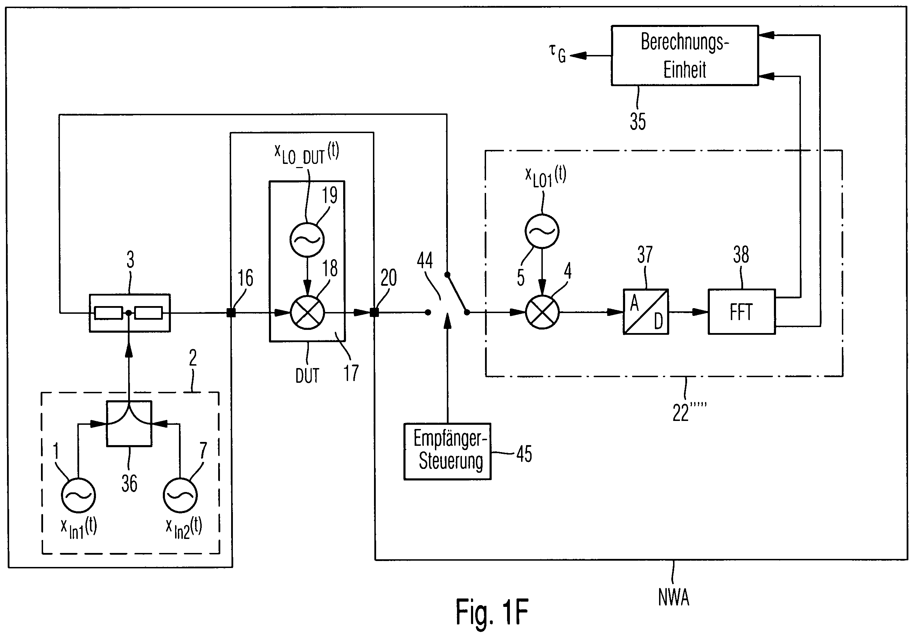

Nach der Digitalisierung des Zwischenfrequenzsignals $x_{InZF1}(t)'$, das zum von der ersten Signalquelle 1 erzeugten Hochfrequenzsignal $x_{InHF1}(t)$ korrespondiert, in einem Analog-Digital-Wandler 8 erfolgt in einem digitalen Mischer 9 mithilfe eines von einem digitalen Oszillator 10 - numeric controlled oscillator (NCO) - erzeugten digitalisierten Trägersignals $x_{NCO1}(t)$, dessen Frequenz $\omega_{NCO1}$ der Frequenz $\omega_{Lo1}-\omega_{In1}$ des auf die erste Signalquelle 1 zurückgehenden Zwischenfrequenzsignals $x_{InZF1}(t)'$ entspricht, eine Mischung des auf die erste Signalquelle 1 zurückgehenden Zwischenfrequenzsignals $x_{InZF1}(t)'$ in ein korrespondierendes Basisbandsignal $x_{InBB1}(t)$ gemäß Gleichung (4). Ein in Fig. 1 nicht dargestelltes, dem digitalen Mischer 9 nachfolgendes Basisbandfilter weist eine Mittenfrequenz von Null auf und ist somit einzig für die am unteren Seitenband des vom digitalen Mischer 9 erzeugten Mischerprodukts gelegene Signal-Komponente des Basisbandsignals $x_{InBB1}(t)$ durchlässig. Das gefilterte Basisbandsignals $x_{InBB1}(t)'$ mit einer Signal-Komponente bei der Frequenz Null ergibt sich gemäß Gleichung (5).

$$x_{InBB1}(t) = x_{InZF1}(t) \cdot x_{NCO1}(t) =$$
$$= e^{-j((\omega_{Lo1} - \omega_{In1}) \cdot t + \varphi_{Lo1} - \varphi_{In1})} \cdot e^{-j(\omega_{NCO1} \cdot t + \varphi_{NCO1})} \qquad (4)$$

$$x_{InBB1}(t)' = e^{-j(\varphi_{Lo1} - \varphi_{In1} - \varphi_{NCO1})} \qquad (5)$$

Äquivalent wird das in einer zweiten Signalquelle 7 der Signalgenerator-Einheit 2 erzeugte Signal $x_{In2}(t)$ des Anregungssignals $x_{In}(t)$, das ebenfalls ein hochfrequentes rein sinusförmiges Signal $x_{InHF2}(t)$, darstellt, nach einer Signalaufsplittung im ersten Mischer 4 mithilfe des Trägersignals $x_{Lo1}(t)$ gemäß Gleichung (6) in ein korrespondierendes Zwischenfrequenzsignal $x_{InZF2}(t)$ gemischt und nach einer Anti-Aliasing-Filterung gemäß Gleichung (7) in einem Tiefpass-Filter 7, dessen Grenzfrequenz zwischen der Frequenz $\omega_{Lo1}-\omega_{In2}$ des unteren Seitenbands und der Frequenz $\omega_{Lo1}+\omega_{In2}$ des oberen Seitenbands des entstandenen Mischerprodukts liegt, ein korrespondierendes Zwischenfrequenzsignal $x_{InZF2}(t)'$ mit einer Signal-Komponente im unteren Seitenband des Mischerprodukts erzeugt.

$$x_{InZF2}(t) = x_{InHF2}(t) \cdot x_{Lo1}(t) = e^{-j(\omega_{In2} \cdot t + \varphi_{In2})} \cdot e^{-j(\omega_{Lo1} \cdot t + \varphi_{Lo1})} \qquad (6)$$

$$x_{InZF2}(t)' = e^{-j((\omega_{Lo1} - \omega_{In2}) \cdot t + \varphi_{Lo1} - \varphi_{In2})} \qquad (7)$$

Nach der Digitalisierung des Zwischenfrequenzsignals $x_{InZF2}(t)'$, das zum von der zweiten Signalquelle 7 erzeugten Hochfrequenzsignal $x_{InHF2}(t)$ korrespondiert, in einem Analog-Digital-Wandler 11 erfolgt in einem digitalen Mischer 12 mithilfe eines von einem digitalen Oszillator 13 erzeugten digitalisierten Trägersignals $x_{NCO2}(t)$, dessen Frequenz $\omega_{NCO2}$ der Frequenz $\omega_{Lo1}-\omega_{In2}$ des auf die zweite Signalquelle 7 zurückgehenden Zwischenfrequenzsignals $x_{InZF2}(t)'$ entspricht, eine Mischung des auf die zweite Signalquelle 7 zurückgehenden Zwischenfrequenzsignals $x_{InZF2}(t)'$ in ein korrespondierendes Basisbandsignal $x_{InBB2}(t)$ gemäß Gleichung (8). Ein in Fig. 1 nicht dargestelltes, dem digitalen Mischer 12 nachfolgendes Basisbandfilter weist eine Mittenfrequenz von Null auf und ist somit einzig für die am unteren Seitenband des vom digitalen Mischer 12 erzeugten Mischerprodukts gelegene Signal-Komponente des Basisbandsignal $x_{InBB2}(t)$ durchlässig. Das gefilterte Basisbandsignal $x_{InBB2}(t)'$ mit einer Signal-Komponente bei der Frequenz Null ergibt sich gemäß Gleichung (9).

$$x_{InBB2}(t) = x_{InZF2}(t) \cdot x_{NCO2}(t) =$$

$$= e^{-j((\omega_{Lo1} - \omega_{In2}) \cdot t + \varphi_{Lo1} - \varphi_{In2})} \cdot e^{-j(\omega_{NCO2} \cdot t + \varphi_{NCO2})} \qquad (8)$$

$$x_{InBB2}(t)' = e^{-j(\varphi_{Lo1} - \varphi_{In2} - \varphi_{NCO2})} \qquad (9)$$

In den Detektor-Einheiten 14 und 15 werden schließlich gemäß Gleichung (10) bzw. (11) die Phasen des auf die erste Signalquelle 1 zurückgehenden basisbandgefilterten Anregungssignals $x_{InBB1}(t)'$ und des auf die zweite Signalquelle 7 zurückgehenden basisbandgefilterten Anregungssignals $x_{InBB2}(t)'$ zum identischen Zeitpunkt $t_0$ ermittelt.

$$\arg\left\{x_{InBB1}(t_0)'\right\} = \varphi_{Lo1} - \varphi_{In1} - \varphi_{NCO1} \qquad (10)$$

$$\arg\left\{x_{InBB2}(t_0)'\right\} = \varphi_{Lo1} - \varphi_{In2} - \varphi_{NCO2} \qquad (11)$$

Die beiden von der ersten und zweiten Signalquelle 1 und 7 erzeugten sinusförmigen Hochfrequenzsignale $x_{InZF1}(t)$ und $x_{InZF2}(t)$ werden nach ihrer Zusammenführung zum hochfrequenten Anregungssignal $x_{InZF}(t)$ in einer Signalverknüpfungs-Einheit 36 über den Signalverteiler 3 nicht nur auf einen Referenzkanal 22 des Netzwerkanalysators, sondern auch über einen ersten Anschluss 16 des Netzwerkanalysators (NWA) dem Messobjekt (DUT) 17 zugeschaltet. Dieses Messobjekt ist bevorzugt als eine Mischerstufe 18 realisierte frequenzkonvertierende Einheit ausgeführt, die von einem lokalen Oszillator 19 mit einem Trägersignal $x_{LO\_DUT}(t)$ versorgt wird. Die frequenzumsetzende Einheit kann gegenüber der Darstellung in Fig. 1A auch aus mehreren kaskadierten Mischerstufen bestehen.

Das an den Eingang des DUTs 17 geführte, von der ersten Signalquelle 1 erzeugte Anregungssignal $x_{InHf1}(t)$ wird mit dem Trägersignal $x_{LO\_DUT}(t)$ des zum Messobjekt 17 gehörigen lokalen Oszillators 19, dessen bekannte Oszillatorfrequenz $\omega_{LO\_DUT}$ sich gemäß Gleichung (12) aus einer unbekannten Sollfrequenz $\omega_{LO\_DUT\_Soll}$ und einer unbekannten Frequenzdrift $\Delta\omega'$ zusammensetzt, gemischt und erfährt im Messobjekt 17 eine Phasenverzerrung um die Phase $\varphi_{DUT1}$. Das Antwortsignal $x_{OutHf1}(t)$ am Ausgang des Messobjekts 17, das von dem von der ersten Signalquelle 1 erzeugten Anregungssignal $x_{InHf1}(t)$ verursacht wird, ergibt sich gemäß Gleichung (13).

$$\omega_{LO\_DUT} = \omega_{LO\_DUT\_Soll} \pm \Delta\omega' \qquad (12)$$

$$x_{OutHf1}(t) = x_{InHF1}(t) \cdot x_{LO\_DUT}(t) \cdot e^{j\varphi_{DUT1}} =$$

$$= e^{-j(\omega_{In1} \cdot t + \varphi_{In1})} \cdot e^{-j((\omega_{LO\_DUT\_Soll} \pm \Delta\omega') \cdot t + \varphi_{LO\_DUT})} \cdot e^{j\varphi_{DUT1}} \qquad (13)$$

Äquivalent wird das von der zweiten Signalquelle 7 erzeugte Anregungssignal $x_{InHf2}(t)$ mit dem Trägersignal $x_{LO\_DUT}(t)$ des zum Messobjekt 17 gehörigen lokalen Oszillators 19 gemischt und erfährt im Messobjekt 17 eine Phasenverzerrung um die Phase $\varphi_{DUT2}$. Das Antwortsignal $x_{OutHf2}(t)$ am Ausgang des Messobjekts 17, das von dem von der zweiten Signalquelle 7 erzeugten Anregungssignal $x_{InHf2}(t)$ verursacht wird, ergibt sich gemäß Gleichung (14).

$$x_{OutHf2}(t) = x_{InHF2}(t) \cdot x_{LO\_DUT}(t) \cdot e^{j\varphi_{DUT2}} =$$

$$= e^{-j(\omega_{In2} \cdot t + \varphi_{In2})} \cdot e^{-j((\omega_{LO\_DUT\_Soll} \pm \Delta\omega') \cdot t + \varphi_{LO\_DUT})} \cdot e^{j\varphi_{DUT2}} \qquad (14)$$

Über den zweiten Anschluss 20 des Netzwerkanalysators werden die beiden zum Antwortsignal $x_{OutHf}(t)$ gehörigen Hochfrequenzsignale $x_{OutHf1}(t)$ und $x_{OutHf2}(t)$ in einem Messkanal 21 des Netzwerkanalysators geführt.

Ein in Fig. 1 nicht dargestelltes Tiefpassfilter, dessen Grenzfrequenz zwischen der Frequenz $\omega_{LO\_DUT\_Soll} - \omega_{In1}$ des unteren Seitenbands und der Frequenz $\omega_{LO\_DUT\_Soll} + \omega_{In1}$ des oberen Seitenbands des im Mischer 18 des Messobjekts 17 erzeugten, auf das Anregungsregungssignal $x_{InHf1}(t)$ der ersten Signalquelle 1 zurückgehenden Mischerprodukts liegt und dessen Bandbreite der doppelten maximal möglichen Frequenzdrift $2 \cdot \Delta\omega'$ des lokalen Oszillators 19 im Messobjekt 17 entspricht, erzeugt gemäß Gleichung (15) ein Antwortsignal $x_{OutHf1}(t)'$, das von dem von der ersten Signalquelle 1 erzeugten Anregungssignal $x_{InHf1}(t)$ verursacht wird, und einzig ein Signal am unteren Seitenband des vom Mischer 18 des Messobjekts 17 erzeugten, auf das Anregungssignal $x_{InHf1}(t)$ der ersten Signalquelle 1 zurückgehende Mischerprodukts aufweist. Ein ebenfalls in Fig. 1A nicht dargestelltes weiteres Tiefpassfilter, dessen Grenzfrequenz zwischen der Frequenz $\omega_{LO\_DUT\_Soll}-\omega_{In2}$ des unteren Seitenbands und der Frequenz $\omega_{LO\_DUT\_Soll}+\omega_{In2}$ des oberen Seitenbands des im Mischer 18 des Messobjekts 17 erzeugten, auf das Anregungssignal $x_{InHf2}(t)$ der zweiten Signalquelle 7 zurückgehende Mischerprodukts liegt und dessen Bandbreite der doppelten maximal möglichen Frequenzdrift $2 \cdot \Delta\omega'$ des lokalen Oszillators 19 im Messobjekt 17 entspricht, erzeugt gemäß Gleichung (16) ein Antwortsignal $x_{OutHf2}(t)'$, das von dem von der zweiten Signalquelle 7 erzeugten Anregungssignal $x_{InHf2}(t)$ verursacht wird und einzig ein Signal am unteren Seitenband des vom Mischer 18 des Messobjekts 17 erzeugten, auf das Anregungssignal $x_{InHf2}(t)$ der zweiten Signalquelle 7 zurückgehenden Mischerprodukts aufweist.

$$x_{OutHf1}(t)' = e^{-j((\omega_{LO\_DUT\_Soll} \pm \Delta\omega' - \omega_{In1}) \cdot t + \varphi_{LO\_DUT} - \varphi_{In1} - \varphi_{DUT1})} \qquad (15)$$

$$x_{OutHf2}(t)' = e^{-j((\omega_{LO\_DUT\_Soll} \pm \Delta\omega' - \omega_{In2}) \cdot t + \varphi_{LO\_DUT} - \varphi_{In2} - \varphi_{DUT2})} \qquad (16)$$

Anschließend wird gemäß Gleichung (18) das hochfrequente Antwortsignal $x_{OutHf1}(t)'$, das von dem in der ersten Signalquelle 1 erzeugten Anregungssignal $x_{InHf1}(t)$ hervorgerufen wird, über einen Mischer 23, der von einem lokalen Oszillator 24 mit einem Trägersignal $x_{Lo2}(t)$, dessen Trägerfrequenz $\omega_{Lo2}$ sich gemäß Gleichung (17) aus der Differenz zwischen der Oszillator-Sollfrequenz $\omega_{LO\_DUT\_Soll}$ des im Messobjekt 17 verwendeten lokalen Oszillators 19 und der Frequenz $\omega_{In1}$ des von der ersten Signalquelle 1 erzeugten hochfrequenten Anregungssignals $x_{InHF1}(t)$ - entspricht der Frequenz des hochfrequenten, tiefpassgefilterten Antwortsignal $x_{OutHf1}(t)'$ bei Anregung mit dem von ersten Signalquelle 1 erzeugten Anregungssignal $x_{InHf1}(t)$ und Vernachlässigung der Frequenzdrift $\Delta\omega$ des lokalen Oszillators 19 im Messobjekt 17 - zuzüglich der Oszillatorfrequenz $\omega_{NCO1}$ eines im Messkanal 21 stromabwärts einem digitalen Mischer 27 zugeführten Trägersignals $x_{NCO1}(t)$ ergibt, in ein zugehöriges Zwischenfrequenzsignal $x_{OutZF1}(t)$ gemischt. Anschließend erfolgt gemäß Gleichung (19) eine Anti-Aliasing-Filterung in einem nachfolgenden Tiefpass-Filter 25, dessen Grenzfrequenz zwischen der Frequenz $\omega_{Lo2}-(\omega_{LO\_DUT\_Soll} - \omega_{In1}) = \omega_{NCO1}$ des unteren Seitenbands und der Frequenz $\omega_{Lo2}+(\omega_{LO\_DUT\_Soll}-\omega_{In1})$ des oberen Seitenbands des im Mischer 23 entstandenen Mischerprodukts liegt. Das Ergebnis der Anti-Aliasing-Filterung ist ein zugehöriges Zwischenfrequenzsignal $x_{OutZF1}(t)'$ mit einer Harmonischen am unteren Seitenband des im Mischer 23 entstandenen Mischerprodukts.

$$\omega_{Lo2} = \omega_{LO\_DUT\_Soll} - \omega_{In1} + \omega_{NCO1} \qquad (17)$$

$$x_{OutZF1}(t) = x_{OutHf1}(t) \cdot x_{Lo2}(t) =$$

$$= e^{-j((\omega_{LO\_DUT\_Soll} \pm \Delta\omega' - \omega_{In1}) \cdot t - \varphi_{In1} + \varphi_{LO\_DUT} - \varphi_{DUT1})} \cdot e^{-j(\omega_{Lo2} \cdot t + \varphi_{Lo2})} =$$

$$= e^{-j((\omega_{LO\_DUT\_Soll} \pm \Delta\omega' - \omega_{In1}) \cdot t - \varphi_{In1} + \varphi_{LO\_DUT} - \varphi_{DUT1})} \cdot e^{-j((\omega_{LO\_DUT\_Soll} - \omega_{In1} + \omega_{NCO1}) \cdot t + \varphi_{Lo2})} \qquad (18)$$

$$x_{OutZF1}(t)' = e^{-j(((\omega_{LO\_DUT\_Soll} - \omega_{In1} + \omega_{NCO1}) - (\omega_{LO\_DUT\_Soll} \pm \Delta\omega' - \omega_{In1})) \cdot t + \varphi_{In1} - \varphi_{LO\_DUT} + \varphi_{DUT1} + \varphi_{Lo2})} =$$

$$= e^{-j((\omega_{NCO1} \pm \Delta\omega') \cdot t + \varphi_{In1} - \varphi_{LO\_DUT} + \varphi_{DUT1} + \varphi_{Lo2})} \qquad (19)$$

Äquivalent wird das hochfrequente tiefpassgefilterte Antwortsignal $x_{OutHf2}(t)'$, das von dem in der zweiten Signalquelle 7 erzeugten Anregungssignal $x_{InHf2}(t)$ hervorgerufen wird, gemäß Gleichung (20) über den Mischer 23 mit dem Trägersignal $x_{Lo2}(t)$ mit der identischen Trägerfrequenz $\omega_{Lo2}$ entsprechend Gleichung (17) in ein zugehöriges Zwischenfrequenzsignal $x_{OutZF2}(t)$ gemischt. Anschließend erfolgt eine Anti-Aliasing-Filterung in einem nachfolgenden Tiefpass-Filter 29, dessen Grenzfrequenz zwischen der Frequenz $\omega_{Lo2} - (\omega_{LO\_DUT\_Soll} - \omega_{In2}) = \omega_{In2} - \omega_{In1} + \omega_{NCO1} = \Delta\omega + \omega_{NCO1} = \omega_{NCO2}$ des am unteren Seitenband und der Frequenz $\omega_{Lo2}+(\omega_{LO\_DUT\_Soll}-\omega_{In2})$ des am oberen Seitenband des im Mischer 23 entstandenen Mischerprodukts bzw. der Oszillatorfrequenz $\omega_{NCO2}$ eines im Messkanal 21 stromabwärts einem weiteren Mischer 31 zugeführten Trägersignals $x_{NCO2}(t)$ entspricht. Gemäß Gleichung (21) wird ein zugehöriges Zwischenfrequenzsignal $\omega_{OutZF2}(t)'$ mit einer Signal-Komponente am unteren Seitenband des im Mischer 23 entstandenen Mischerprodukts erzeugt.

$$x_{OutZF2}(t) = x_{OutHf2}(t) \cdot x_{Lo2}(t) =$$

$$= e^{-j((\omega_{LO\_DUT\_Soll} \pm \Delta\omega' - \omega_{In2}) \cdot t - \varphi_{In1} + \varphi_{LO\_DUT} - \varphi_{DUT2})} \cdot e^{-j(\omega_{Lo2} \cdot t + \varphi_{Lo2})} =$$

$$= e^{-j((\omega_{LO\_DUT\_Soll} \pm \Delta\omega' - \omega_{In2}) \cdot t - \varphi_{In2} + \varphi_{LO\_DUT} - \varphi_{DUT2})} \cdot e^{-j((\omega_{LO\_DUT\_Soll} - \omega_{In1} + \omega_{NCO1}) \cdot t + \varphi_{Lo2})} \quad (20)$$

$$x_{OutZF2}(t)' = e^{-j(((\omega_{LO\_DUT\_Soll} - \omega_{In1} + \omega_{NCO1}) - (\omega_{LO\_DUT\_Soll} \pm \Delta\omega' - \omega_{In2})) \cdot t + \varphi_{In2} - \varphi_{LO\_DUT} + \varphi_{DUT2} + \varphi_{Lo2})} =$$

$$= e^{-j((\omega_{NCO1} \pm \Delta\omega' + \omega_{In2} - \omega_{In1}) \cdot t + \varphi_{In2} - \varphi_{LO\_DUT} + \varphi_{DUT2} + \varphi_{Lo2})} =$$

$$= e^{-j((\omega_{NCO1} \pm \Delta\omega' + \Delta\omega) \cdot t + \varphi_{In2} - \varphi_{LO\_DUT} + \varphi_{DUT2} + \varphi_{Lo2})} =$$

$$= e^{-j((\omega_{NCO2} \pm \Delta\omega') \cdot t + \varphi_{In2} - \varphi_{LO\_DUT} + \varphi_{DUT2} + \varphi_{Lo2})} \quad (21)$$

Das gefilterte Zwischenfrequenzsignal $x_{OutZF1}(t)'$, das aus einer Anregung des DUT 17 mit dem von der ersten Signalquelle 1 erzeugten Anregungssignal $x_{InHF1}(t)$ hervorgeht, wird in einem nachfolgenden Analog-Digitalwandler 26 digitalisiert und in einem digitalen Mischer 27, dem vom lokalen Oszillator 10 ein Trägersignal $x_{NCO1}(t)$ zugeführt wird, in ein zugehöriges Basisbandsignal $x_{OutBB1}(t)$ gemäß Gleichung (22) gemischt. Ein in Fig. 1 nicht dargestelltes, dem digitalen Mischer 27 nachfolgendes Basisbandfilter weist eine Mittenfrequenz von Null auf und ist somit einzig für die am unteren Seitenband des vom digitalen Mischer 21 erzeugten Mischerprodukts gelegene Signal-Komponente des Basisbandsignal $x_{OutBB1}(t)$ durchlässig.

Das zugehörige gefilterte Basisbandsignal $x_{OutBB1}(t)'$ ergibt sich gemäß Gleichung (23).

$$x_{OutBB1}(t) = x_{OutZF1}(t)' \cdot x_{NCO1}(t) =$$

$$= e^{-j((\omega_{NCO1} \pm \Delta\omega') \cdot t - \varphi_{In1} + \varphi_{LO\_DUT} - \varphi_{DUT1} + \varphi_{Lo2})} \cdot e^{-j(\omega_{NCO1} \cdot t + \varphi_{NCO1})} = \quad (22)$$

$$x_{OutBB1}(t)' = e^{-j(\pm \Delta\omega' \cdot t - \varphi_{In1} + \varphi_{LO\_DUT} - \varphi_{DUT1} + \varphi_{Lo2} - \varphi_{NCO1})} \quad (23)$$

Äquivalent wird das Zwischenfrequenzsignal $x_{OutZF2}(t)'$, das aus einer Anregung des DUT 17 mit dem von der zweiten Signalquelle 7 erzeugten Anregungssignal $x_{InHF2}(t)$ hervorgeht, in einem nachfolgenden Analog-Digitalwandler 30 digitalisiert und in einem digitalen Mischer 31, dem vom lokalen Oszillator 13 ein Trägersignal $x_{NCO2}(t)$ zugeführt wird, in ein zugehöriges Basisbandsignal $x_{OutBB2}(t)$ gemäß Gleichung (24) gemischt. Ein in Fig. 1 nicht dargestelltes, dem digitalen Mischer 31 nachfolgendes Basisbandfilter weist eine Mittenfrequenz von Null auf und ist somit einzig für die am unteren Seitenband des vom digitalen Mischer 31 erzeugten Mischerprodukts gelegene Signal-Komponente des Basisbandsignal $x_{OutBB2}(t)$ durchlässig.

Das zugehörige gefilterte Basisbandsignal $x_{OutBB2}(t)'$ ergibt sich gemäß Gleichung (25).

$$x_{OutBB2}(t) = x_{OutZF2}(t)' \cdot x_{NCO2}(t) =$$

$$= e^{-j((\omega_{NCO2} \pm \Delta\omega') \cdot t - \varphi_{In2} + \varphi_{LO\_DUT} - \varphi_{DUT2} + \varphi_{Lo2})} \cdot e^{-j(\omega_{NCO2} \cdot t + \varphi_{NCO2})} = \quad (24)$$

$$x_{OutBB2}(t)' = e^{-j(\pm \Delta\omega' \cdot t - \varphi_{In2} + \varphi_{LO\_DUT} - \varphi_{DUT2} + \varphi_{Lo2} - \varphi_{NCO2})} \quad (25)$$

Die digitalen Mischer 9 bzw. 12 im Referenzkanal und die digitalen Mischer 27 bzw. 31 im Messkanal werden gleichzeitig gestartet und sind bis zum Ende des Abtastprozesses der beiden Antwortsignale im Zwischenfrequenzband $x_{OutZF1}(t)'$ und $x_{OutZF2}(t)'$ in Betrieb.

In den Detektor-Einheiten 33 und 34 werden schließlich gemäß Gleichung (26) bzw. (27) die Phasen des auf die erste Signalquelle 1 zurückgehenden basisbandgefilterte Antwortsignal $x_{OutBB1}(t)'$ und des auf die zweite Signalquelle 7 zurückgehenden basisbandgefilterte Antwortsignals $x_{OutBB2}(t)'$ zum identischen Zeitpunkt $t_0$ ermittelt.

$$\arg\left\{x_{OutBB1}(t_0)'\right\} = \pm\Delta\omega'\cdot t - \varphi_{In1} + \varphi_{LO\_DUT} - \varphi_{DUT1} + \varphi_{Lo2} - \varphi_{NCO1} \qquad (26)$$

$$\arg\left\{x_{OutBB2}(t_0)'\right\} = \pm\Delta\omega'\cdot t - \varphi_{In2} + \varphi_{LO\_DUT} - \varphi_{DUT2} + \varphi_{Lo2} - \varphi_{NCO2} \qquad (27)$$

In einer Berechnungseinheit 35 wird gemäß Gleichung (28) die Phasendifferenz $\Delta\varphi_{In}$ zwischen der Phase $\arg\{x_{InBB1}(t_0)'\}$ des auf die erste Signalquelle 1 zurückgehenden basisbandgefilterte Anregungssignals $x_{InBB1}(t)'$ und der Phase $\arg\{x_{InBB2}(t_0)'\}$ des auf die zweite Signalquelle 7 zurückgehenden basisbandgefilterte Anregungssignals $x_{InBB2}(t)'$ und gemäß Gleichung (29) die Phasendifferenz $\Delta\varphi_{Out}$ zwischen der Phase $\arg\{x_{OutBB1}(t_0)'\}$ des auf die erste Signalquelle 1 zurückgehenden basisbandgefilterte Antwortsignals $x_{OutBB1}(t)'$ und der Phase $\arg\{x_{OutBB2}(t_0)'\}$ des auf die zweite Signalquelle 7 zurückgehenden basisbandgefilterte Antwortsignals $x_{OutBB2}(t)'$ berechnet.

$$\Delta\varphi_{In} = \arg\left\{x_{InBB1}(t_0)'\right\} - \arg\left\{x_{InBB2}(t_0)'\right\} =$$

$$= -\varphi_{In1} - \varphi_{NCO1} - \left(-\varphi_{In2} - \varphi_{NCO2}\right) \qquad (28)$$

$$\Delta\varphi_{Out} = \arg\left\{x_{OutBB1}(t_0)'\right\} - \arg\left\{x_{OutBB2}(t_0)'\right\} =$$

$$= -\varphi_{In1} - \varphi_{DUT1} - \varphi_{NCO1} - \left(-\varphi_{In2} - \varphi_{DUT2} - \varphi_{NCO2}\right) \qquad (29)$$

Ausgehend von der Definition der Gruppenlaufzeit $\tau_G$ in Gleichung (1) ergibt sich die Gruppenlaufzeit $\tau_G$ gemäß Gleichung (30) als Differenz der Phasenverzerrungen $\varphi_{DUT1}$ -$\varphi_{DUT2}$, die die beiden im Anregungssignal $x_{In}(t)$ enthaltenen Signal-Komponenten im Messobjekt 17 erfahren, die um den Frequenzabstand $\Delta\omega$ zwischen den beiden Signal-Komponenten normiert wird.

$$\tau_G = \frac{-1}{360°}\cdot\frac{\Delta\varphi}{\Delta f} = \frac{-1}{360°}\cdot\frac{\Delta\varphi_{In} - \Delta\varphi_{Out}}{\Delta\omega} =$$

$$= \frac{-1}{360°}\cdot\frac{\varphi_{DUT1} - \varphi_{DUT2}}{\Delta\omega} \qquad (30)$$

In einer zweiten Ausführungsform der Erfindung wird in Anlehnung an die erste Ausführungsform der Erfindung das in einer ersten Signalquelle 1 der Signalgenerator-Einheit 2 erzeugte Signal $x_{In1}(t)$ des Anregungssignals $x_{In}(t)$, das ein hochfrequentes Eintonsignal $x_{InHF1}(t)$ ist, in einem ersten Mischer 4 mithilfe eines von einem lokalen Oszillator 5 erzeugten Trägersignals $x_{Lo1}(t)$ in ein Signal $x_{InDown1}(t)$ im Zwischenfrequenz- oder Basisband gemäß Gleichung (3') gemischt.

$$x_{InDown1}(t)' = e^{-j\left((\omega_{Lo1} - \omega_{In1})\cdot t + \varphi_{Lo1} - \varphi_{In1}\right)} \qquad (3')$$

Äquivalent wird das in einer zweiten Signalquelle 7 der Signalgenerator-Einheit 2 erzeugte Signal $x_{In2}(t)$ des Anregungssignals $x_{In}(t)$, das ebenfalls ein hochfrequentes rein sinusförmiges Signal $x_{InHF2}(t)$, darstellt, im ersten Mischer 4 mithilfe des Trägersignals $x_{Lo1}(t)$ gemäß Gleichung (7') in ein korrespondierendes Signal $x_{InDown2}(t)$ im Zwischenfrequenz- oder Basisband gemischt.

$$x_{InDown2}(t)' = e^{-j\left((\omega_{Lo1} - \omega_{In2})\cdot t + \varphi_{Lo1} - \varphi_{In2}\right)} \qquad (7')$$

Nach Analog-Digital-Wandlung der beiden Zwischenfrequenz (ZF)- oder Basisbandsignale $x_{InDown1}(t)$ und $x_{InDown2}(t)$ in einem Analog-Digital-Wandler 37 erfolgt in einem Fast-Fourier-Transformator 38 die Ermittlung der korrespondierenden komplexen Spektrallinien der beiden Zwischenfrequenz- oder Basisbandsignale $x_{InDown1}(t)$ und $x_{InDown2}(t)$.

Im Fast-Fourier-Transformator 38 werden die Phasen $\arg\{x_{InDown1}(t_0)\}$ und $\arg\{x_{InDown2}(t_0)\}$ der komplexen Spektrallinien des zum Anregungssignal $x_{In}(t)$ gehörigen Zwischenfrequenz- bzw. Basisbandsignale $x_{InDown1}(t)$ und $x_{InDown2}(t)$ zum Zeitpunkt $t_0$ gemäß Gleichung (10') und (11') bestimmt.

$$\arg\left\{x_{InDown1}(t_0)\right\} = (\omega_{Lo1} - \omega_{In1})\cdot t_0 + \varphi_{Lo1} - \varphi_{In1} \qquad (10')$$

$$\arg\left\{x_{InDown2}(t_0)\right\} = (\omega_{Lo1} - \omega_{In2})\cdot t_0 + \varphi_{Lo1} - \varphi_{In2} \qquad (11')$$

In Anlehnung an die erste Ausführungsform der Erfindung wird das vom DUT 17 erzeugte hochfrequente Antwortsignal $x_{OutHf1}(t)$' gemäß Gleichung (15), das von dem in der ersten Signalquelle 1 erzeugten Anregungssignal $x_{InHf1}(t)$ hervorgerufen wird, in einen Mischer 23, der von einem lokalen Oszillator 24 mit einem Trägersignal $x_{Lo2}(t)$ gespeist wird, gemäß Gleichung (19') in ein zugehöriges Signal $x_{OutDown1}(t)$ im Zwischenfrequenz- oder Basisband gemischt.

$$x_{OutDown1}(t) = e^{-j((\omega_{Lo2} - \omega_{In1} + \omega_{LO\_DUT\_Soll} \pm \Delta\omega')\cdot t - \varphi_{In1} + \varphi_{LO\_DUT} - \varphi_{DUT1} + \varphi_{Lo2})} \qquad (19')$$

Äquivalent wird das hochfrequente bandpassgefilterte Antwortsignal $x_{OutHf2}(t)$' gemäß Gleichung (16), das von dem in der zweiten Signalquelle 7 erzeugten Anregungssignal $x_{InHf2}(t)$ hervorgerufen wird, gemäß Gleichung (21') über den Mischer 23 mit dem Trägersignal $x_{Lo2}(t)$ in ein zugehöriges Signal $x_{OutDown2}(t)$ im Zwischenfrequenz- oder Basisband gemischt.

$$x_{OutDown2}(t) = e^{-j((\omega_{Lo2} - \omega_{In2} + \omega_{LO\_DUT\_Soll} \pm \Delta\omega')\cdot t - \varphi_{In2} + \varphi_{LO\_DUT} - \varphi_{DUT2} + \varphi_{Lo2})} \qquad (21')$$

Nach Analog-Digital-Wandlung der beiden Zwischenfrequenz (ZF)- oder Basisbandsignale $x_{OutDown1}(t)$ und $x_{OutDown2}(t)$ in einem Analog-Digital-Wandler 39 erfolgt in einem Fast-Fourier-Transformator 40 die Ermittlung der korrespondierenden komplexen Spektrallinien der beiden ZF- oder Basisbandsignale $x_{OutDown1}(t)$ und $x_{OutDown2}(t)$. Die Analog-Digital-Wandlung im Analog-Digital-Wandler 39 startet zur selben Zeit wie die Analog-Digital-Wandlung im Analog-Digital-Wandler 37.

Im Fast-Fourier-Transformator 40 werden die Phasen $\arg\{x_{OutDown1}(t_0)\}$ und $\arg\{x_{OutDown2}(t_0)\}$ der komplexen Spektrallinien der beiden ZF- oder Basisbandsignale $x_{OutDown2}(t)$ und $x_{OutDown2}(t)$ zum synchronen Zeitpunkt $t_0$ gemäß Gleichung (26') und (27') bestimmt.

$$\arg\left\{x_{OutDown1}(t_0)\right\} = (\omega_{Lo2} - \omega_{In1} + \omega_{LO\_DUT\_Soll} \pm \Delta\omega')\cdot t_0 - \varphi_{In1} + \varphi_{LO\_DUT} - \varphi_{DUT1} + \varphi_{Lo2}$$
$$(26')$$

$$\arg\left\{x_{OutDown2}(t_0)\right\} = (\omega_{Lo2} - \omega_{In2} + \omega_{LO\_DUT\_Soll} \pm \Delta\omega')\cdot t_0 - \varphi_{In2} + \varphi_{LO\_DUT} - \varphi_{DUT2} + \varphi_{Lo2}$$
$$(27')$$

In der Berechnungseinheit 35 wird die Phasendifferenz $\Delta\varphi_{In}$ zwischen den Phasen $\arg\{x_{InDown1}(t_0)\}$ und $\arg\{x_{InDown2}(t_0)\}$ der komplexen Spektrallinien der beiden zum Anregungssignal gehörigen ZF- oder Basisbandsignale $x_{InDown1}(t)$ und $x_{InDown2}(t)$ zum Zeitpunkt $t_0$ gemäß Gleichung (28') ermittelt.

$$\Delta\varphi_{In} = \arg\left\{x_{InDown1}(t_0)\right\} - \arg\left\{x_{InDown2}(t_0)\right\} = -\Delta\omega\cdot t_0 - \varphi_{In1} + \varphi_{In2} \qquad (28')$$

Äquivalent wird in der Berechnungseinheit 35 die Phasendifferenz $\Delta\varphi_{Out}$ zwischen den Phasen $\arg\{x_{OutDown1}(t_0)\}$ und $\arg\{x_{OutDown2}(t_0)\}$ der komplexen Spektrallinien der beiden zum Antwortsignal gehörigen ZF-

oder Basisbandsignale $x_{OutDown1}(t)$ und $x_{OutDown2}(t)$ zum Zeitpunkt $t_0$ gemäß Gleichung (29') ermittelt.

$$\Delta\varphi_{Out} = \arg\left\{x_{OutDown1}(t_0)\right\} - \arg\left\{x_{OutDown2}(t_0)\right\} = -\Delta\omega \cdot t_0 - \varphi_{In1} + \varphi_{In2} - \varphi_{DUT1} + \varphi_{DUT2}$$

$$(29')$$

Durch Einfügen der Terme für die Phasendifferenzen $\Delta\varphi_{In}$ und $\Delta\varphi_{Out}$ aus Gleichung (28') und (29') in die Gleichung (30) der ersten Ausführungsform der Erfindung ergibt sich für die Gruppenlaufzeit $\tau_G$ der zweite Ausführungsform der Erfindung derselbe Term wie im Fall der ersten Ausführungsform der Erfindung.

In einer zweiten, dritten und vierten Ausführungsform der Erfindung werden nach einer Mischung der beiden sinusförmigen Signale des Anregungssignals ins Zwischenfrequenzband durch einen gemeinsamen lokalen Oszillator 5 und einer Umschaltdauer $\Delta t$ die beiden sinusförmigen Signale des Antwortsignals durch den gemeinsamen lokalen Oszillator 5 ins Zwischenfrequenzband gemischt. Alternativ können zuerst die beiden sinusförmigen Signale des Antwortsignals durch den gemeinsamen lokalen Oszillator 5 ins Zwischenfrequenzband und nach einer Umschaltdauer $\Delta t$ die beiden sinusförmigen Signale des Anregungssignals ins Zwischenfrequenzband gemischt werden. Wird die Gruppenlaufzeit $\tau_G$ nicht nur einmalig, sondern kontinuierlich ermittelt, so wird die Frequenz des gemeinsamen lokalen Oszillators 5 zyklisch mit einer Umschaltdauer $\Delta t$ zwischen den im Messkanal und dem im Referenzkanal befindlichen Mischer 4 und 23 geschaltet.

Im Folgenden wird der Fall der auf die Mischung der beiden sinusförmigen Signale des Anregungssignals nachfolgenden Mischung der beiden sinusförmigen Signale des Antwortsignals beschrieben. Für die übrigen Fälle ergibt sich jeweils eine äquivalente mathematische Herleitung.

Für das zum hochfrequenten Eintonsignal $x_{OutHF1}(t)$ des Antwortsignals $x_{Out}(t)$ korrespondierende Zwischenfrequenzsignal $x_{OutZF1}(t+\Delta t)$ zum Abtastzeitpunkt $t+\Delta t$ und für das zum hochfrequenten Eintonsignal $x_{OutHF2}(t)$ des Anregungssignals $x_{Out}(t)$ korrespondierende Zwischenfrequenzsignal $x_{OutZF2}(t+\Delta t)$ zum Abtastzeitpunkt $t+\Delta t$ ergibt sich die mathematische Beziehung in Gleichung (18") und (20").

$$x_{OutZF1}(t + \Delta t) = e^{-j((\omega_{LO\_DUT\_Soll} \pm \Delta\omega' - \omega_{In1})\cdot(t+\Delta t) - \varphi_{In1} + \varphi_{LO\_DUT} - \varphi_{DUT1})} \cdot e^{-j((\omega_{Lo1})\cdot(t+\Delta t) + \varphi_{Lo1})} \quad (18'')$$

$$x_{OutZF2}(t) = e^{-j((\omega_{LO\_DUT\_Soll} \pm \Delta\omega' - \omega_{In2})\cdot(t+\Delta t) - \varphi_{In2} + \varphi_{LO\_DUT} - \varphi_{DUT2})} \cdot e^{-j((\omega_{Lo1})\cdot(t+\Delta t) + \varphi_{Lo1})} \quad (20'')$$

In Anti-Aliasing-Filtern 25 und 29 werden die Signalanteile $x_{OutZF1}(t)'$ und $x_{OutZF2}(t)'$ an den unteren Seitenbändern der beiden Zwischenfrequenzsignale und $x_{OutZF2}(t+\Delta t)$ in Anlehnung an Gleichung (19) und (21) in der ersten Ausführungsform gemäß Gleichung (19") und (21") ermittelt.

$$x_{OutZF1}(t)' = e^{-j((\omega_{Lo1} - \omega_{LO\_DUT\_Soll} \pm \Delta\omega' + \omega_{In1})\cdot(t+\Delta t) + \varphi_{In1} - \varphi_{LO\_DUT} + \varphi_{DUT1} + \varphi_{Lo1})} \quad (19'')$$

$$x_{OutZF2}(t)' == e^{-j((\omega_{Lo1} - \omega_{LO\_DUT\_Soll} \pm \Delta\omega' + \omega_{In2})\cdot(t+\Delta t) + \varphi_{In2} - \varphi_{LO\_DUT} + \varphi_{DUT2} + \varphi_{Lo1})} \quad (21'')$$

Für das zum hochfrequenten Eintonsignal $x_{OutHF1}(t)$ des Antwortsignals $x_{Out}(t)$ korrespondierende Basisbandsignal $x_{OutBB1}(t+\Delta t)'$ zum Abtastzeitpunkt $t + \Delta t$ und für das zum hochfrequenten Eintonsignal $x_{OutHF2}(t)$ des Anregungssignals $x_{Out}(t)$ korrespondierende Basisbandsignal $x_{OutBB2}(t+\Delta t)'$ zum Abtastzeitpunkt $t+\Delta t$ ergibt sich unter der Voraussetzung, dass sich die Phase der beiden lokalen Oszillatoren 9 und 13 während der Umschaltdauer $\Delta t$ der Schalter 41, 42, 43 und 44 auch um $\Delta t$ ändert, und unter der Voraussetzung, dass $\omega_{NCO1} = \omega_{Lo1}$ - $\omega_{LO\_DUT\_Soll}$ + $\omega_{In1}$ und $\omega_{NCO2} = \omega_{Lo1}$ - $\omega_{LO\_DUT\_Soll}$ + $\omega_{In2}$ bzw. $\omega_{NCO1} - \omega_{NCO2} = \omega_{In1} - \omega_{In2}$ ist, die mathematische Beziehung in Gleichung (22") und (23") bzw. (24") und (25").

$$x_{OutBB1}(t + \Delta t) = x_{OutZF1}(t + \Delta t)' \cdot x_{NCO1}(t + \Delta t) =$$

$$= e^{-j((\omega_{Lo1} - \omega_{LO\_DUT\_Soll} \pm \Delta\omega' + \omega_{In1})\cdot(t+\Delta t) - \varphi_{In1} + \varphi_{LO\_DUT} - \varphi_{DUT1} + \varphi_{Lo1})} \cdot e^{-j(\omega_{NCO1}\cdot(t+\Delta t) + \varphi_{NCO1})} \quad (22'')$$

$$x_{OutBB1}(t + \Delta t)' = e^{-j((\pm\Delta\omega')\cdot(t+\Delta t) - \varphi_{In1} + \varphi_{LO\_DUT} - \varphi_{DUT1} + \varphi_{Lo1} - \varphi_{NCO1})} \quad (23'')$$

$$x_{OutBB2}(t + \Delta t) = x_{OutZF2}(t + \Delta t)' \cdot x_{NCO2}(t + \Delta t) =$$

$$= e^{-j((\omega_{Lo1} - \omega_{LO\_DUT\_Soll} \pm \Delta\omega' + \omega_{In2}) \cdot (t + \Delta t) - \varphi_{In2} + \varphi_{LO\_DUT} - \varphi_{DUT2} + \varphi_{Lo1})} \cdot e^{-j(\omega_{NCO2} \cdot (t + \Delta t) + \varphi_{NCO2})} \quad (24'')$$

$$x_{OutBB2}(t + \Delta t)' = e^{-j((\pm\Delta\omega') \cdot (t + \Delta t) - \varphi_{In2} + \varphi_{LO\_DUT} - \varphi_{DUT2} + \varphi_{Lo1} - \varphi_{NCO2})} \quad (25'')$$

Bildet man die Differenz zwischen den Phasen arg{$x_{OutBB1}(t+\Delta t)'$} und arg{$x_{OutBB2}(t+\Delta t)'$} der beiden Basisbandsignalen $x_{OutBB1}(t+\Delta t)'$ und $x_{OutBB2}(t+\Delta t)'$, so erhält man dieselbe Phasendifferenz $\Delta\varphi_{Out}$ wie in der entsprechenden Gleichung (29) zur ersten Ausführungsform der Erfindung.

Zur Umschaltung des lokalen Oszillators 5 mit dem lokalen Oszillatorsignal $x_{Lo1}(t)$ zwischen Referenzkanal 22" und Messkanal 21" über einen Schalter 41 weist die dritte Ausführungsform der Erfindung eine Lokal-Oszillator-Steuerung 44 auf. Anstelle eines Schalters 41 kann auch ein Leistungsteiler zum Einsatz kommen.

Analog weist die vierte Ausführungsform der Erfindung zur Umschaltung des lokalen Oszillators 5 mit dem lokalen Oszillatorsignal $x_{Lo1}(t)$ über einen Schalter 41, zur Umschaltung des lokalen Oszillators 13 mit dem lokalen Oszillatorsignal $x_{NCO1}(t)$ über den Schalter 42 und zur Umschaltung des lokalen Oszillators 10 mit dem lokalen Oszillatorsignal $x_{NCO2}(t)$ über den Schalter 43 zwischen Referenzkanal 22''' und Messkanal 21''' eine LokalOszillator-Steuerung 44' auf. Auch die Schalter 42 und 43 können alternativ durch jeweils einen Leistungsteiler ersetzt werden.

Zum Umschalten des einzigen Messkanals 2"" des Netzwerkanalysators vom ersten Anschluss 16 zum zweiten Anschlusses 20 weist die fünfte Ausführungsform der Erfindung einen Schalter 44 auf, der von einer Empfänger-Steuerung 45 angesteuert wird.

Hervorzuheben ist, dass in der vierten Ausführungsform in Anlehnung an die dritte Ausführungsform der Erfindung der lolake Oszillator 13 mit dem lokalen Oszillatorsignal $x_{NCO1}(t)$ zwischen der Oszillatorfrequenz $\omega_{NCO1} = \omega_{Lo1} - \omega_{In1}$ bei Zuschaltung des Anregungssignals $x_{In}(t)$ und der Oszillatorfrequenz $\omega_{NCO1} = \omega_{Lo1} - \omega_{LO\_DUT\_Soll} + \omega_{In1}$ bei Zuschaltung des Antwortsignals $x_{Out}(t)$ an den gemeinsamen Messkanal 22"" und der lokale Oszillator 13 mit dem lokalen Oszillatorsignal $x_{NCO2}(t)$ zwischen der Oszillatorfrequenz $\omega_{NCO2} = \omega_{Lo1} - \omega_{In2}$ bei Zuschaltung des Anregungssignals $x_{In}(t)$ und der Oszillatorfrequenz $\omega_{NCO2} = \omega_{Lo1} - \omega_{LO\_DUT\_Soll} + \omega_{In2}$ bei Zuschaltung des Antwortsignals $x_{Out}(t)$ an den gemeinsamen Messkanal 22"" eingestellt werden muss.

Die fünfte Ausführungsform der Erfindung stellt eine Kombination der zweiten und vierten Ausführungsform der Erfindung dar. Auf eine mathematische Herleitung der fünften Ausführungsform der Erfindung wird deshalb in diesem Zusammenhang verzichtet.

Ausgehend von der gemäß Gleichung (30) ermittelten Gruppenlaufzeit $\tau_G$ läßt sich durch Integration der Gruppenlaufzeit die i.a. nicht-lineare Phase $\varphi$ gemäß Gleichung (31) ermitteln.

$$\varphi = -360° \cdot \int_{f_a}^{f_e} \tau_G(f) df + C \quad (31)$$

Numerisch lässt sich die Integration in Gleichung (31) durch eine Summe gemäß Gleichung (32) nähern.

$$\varphi(f_n) = \begin{cases} 0 & n = 1 \\ -360° \cdot \sum_{i=2}^{n} \dfrac{\tau_G(f_i) + \tau_G(f_{i-1})}{2} \cdot (f_i - f_{i-1}) & n \geq 2 \end{cases} \quad (32)$$

Ausgehend von dieser mathematischen Herleitung für die Gruppenlaufzeit $\tau_G$, die von einem Messobjekt 17 verursacht wird, wird im Folgenden die erste Ausführungsform des erfindungsgemäßen Verfahrens zur Messung der Gruppenlaufzeit $\tau_G$ in einem Messobjekt mit einem Netzwerkanalysator für die erste, dritte, vierte und fünfte Ausführungsform des erfindungsgemäßen Systems anhand des Flussdiagramms in Fig. 2A beschrieben:
Im ersten Verfahrensschritt S10 wird in der Signalgenerator-Einheit 2 des Netzwerkanalysators ein Anregungssignal $x_{In}(t)$ erzeugt, das als Zweitonsignal aus den beiden hochfrequenten sinusförmigen Signalen $x_{InHF1}(t)$ und $x_{InHF2}(t)$ gemäß Gleichung (2) und (6) im Frequenzabstand $\Delta\omega$ besteht.

Im nächsten Verfahrensschritt S20 wird das Anregungssignal $x_{In}(t)$ über einen Signalverteiler 3 und einen ersten Anschluss 16 aus den Netzwerkanalysator geführt und an den Eingang des frequenzkonvertierenden Messobjekts 17 zur Anregung des Messobjekts 17 angelegt. Am Ausgang des Messobjekts 17 wird das vom Anregungssignal $x_{In}(t)$ verursachte Antwortsignal $x_{Out}(t)$ gemessen, indem es über einen zweiten Anschluss 20 in einen Messkanal 21 in der ersten Ausführungsform des erfindungsgemäßen Systems, in einen Messkanal 21" in der dritten Ausführungsform des erfindungsgemäßen Systems, in einen Messkanal 21'" in der vierten Ausführungsform des erfindungsgemäßen Systems oder über einen Schalter 44 in einen Referenzkanal 22"" in der fünften Ausführungsform des erfindungsgemäßen Systems geführt.

Über den Signalverteiler 3 wird das erzeugte Anregungssignal $x_{In}(t)$ zusätzlich in einem Referenzkanal 22 in der ersten Ausführungsform des erfindungsgemäßen Systems, in einen Referenzkanal 22" in der dritten Ausführungsform des erfindungsgemäßen Systems, in einen Referenzkanal 22'" in einer vierten Ausführungsform des erfindungsgemäßen Systems oder über einen Schalter 44 in einen Referenzkanal 22"" in einer fünften Ausführungsform des erfindungsgemäßen Systems einem Mischer 4 zugeführt, um die beiden Signale $x_{InHF1}(t)$ und $x_{InHF2}(t)$ gemäß Gleichung (2) und (6) ins Zwischenfrequenzband zu mischen, wobei die beiden Zwischenfrequenzsignale $x_{InHF1}(t)$ und $x_{InHF2}(t)$ des Anregungssignals $x_{In}(t)$ in der dritten, vierten und fünften Ausführungsform des erfindungsgemäßen Systems aufgrund der Umschaltung zur sequentiellen Messung von Anregungs- und Antwortsignal in jedem Umschaltzyklus gegenüber den Signalen $x_{OutZF1}(t)$ und $x_{OutZF2}(t)$ des Antwortsignal $x_{Out}(t)$ um die Umschaltdauer $\Delta t$ zeitlich verschoben sind.

Äquivalent werden die beiden Signal-Komponenten $x_{OutHf1}(t)$ und $x_{OutHf2}(t)$ des erfassten Antwortsignals $x_{Out}(t)$ in einem Mischer 23 gemäß Gleichung (18) und (20) ins Zwischenfrequenzband gemischt, wobei die Zwischenfrequenzsignale $x_{OutZF1}(t)$ und $x_{OutZF2}(t)$ des Antwortsignal $x_{Out}(t)$ in der dritten, vierten und fünften Ausführungsform des erfindungsgemäßen Systems aufgrund der Umschaltung zwischen Anregungs- und Antwortsignal in jedem Umschaltzyklus gegenüber den Zwischenfrequenzsignalen $x_{InHF1}(t)$ und $x_{InHF2}(t)$ des Anregungssignals $x_{In}(t)$ gemäß Gleichung (18") und (20") um die Umschaltdauer $\Delta t$ zeitlich verschoben sind.

Im nächsten Verfahrensschritt S40 werden die beiden im vorherigen Verfahrensschritt erzeugten Zwischenfrequenzsignale $x_{InZF1}(t)$ und $x_{InZF2}(t)$, die auf das Anregungssignal $x_{In}(t)$ zurückgehen, in als Bandpassfilter realisierten Zwischenfrequenz-Filtern 6 und 7 auf jeweils einen Signalpfad verteilt und einzig die Signal-Komponenten (Teilsignale) $x_{InZF1}(t)'$ und $x_{InZF2}(t)'$ am jeweiligen unteren Seitenband des erzeugten Mischerprodukts gemäß Gleichung (6) und (7) weiterverfolgt, wobei die zum Anregungssignal $x_{In}(t)$ gehörigen Signal-Komponenten (Teilsignale) $x_{InZF1}(t)'$ und $x_{InZF2}(t)'$ in der dritten, vierten und fünften Ausführungsform des erfindungsgemäßen Systems in jedem Umschaltzyklus gegenüber den zum Antwortsignal $x_{Out}(t)$ gehörigen Signal-Komponenten (Teilsignale) $x_{OutZF1}(t)'$ und $x_{OutZF2}(t)'$ um die Umschaltdauer $\Delta t$ zeitlich verschoben sind. Die Zwischenfrequenzsignale $x_{OutZF1}(t)$ und $x_{OutZF2}(t)$, die auf das Antwortsignal $x_{Out}(t)$ zurückgehen, werden ebenfalls in als Bandpassfilter realisierten Zwischenfrequenz-Filtern 25 und 29 auf jeweils einen Signalpfad verteilt und einzig die Signal-Komponenten $x_{OutZF1}(t)'$ und $x_{OutZF2}(t)'$ am jeweiligen unteren Seitenband des erzeugten Mischerprodukts gemäß Gleichung (19) und (21) weiterverfolgt, wobei die zum Antwortsignal $x_{Out}(t)$ gehörigen Zwischenfrequenzsignal-Komponenten $x_{OutZF1}(t)'$ und $x_{OutZF2}(t)'$ in der dritten, vierten und fünften Ausführungsform des erfindungsgemäßen Systems gemäß Gleichung (19") und (21") gegenüber den zum Anregungssignal $x_{In}(t)$ gehörigen Zwischenfrequenzsignalkomponenten $x_{InZF1}(t)'$ und $x_{InZF2}(t)'$ in jedem Umschaltzyklus um die Umschaltdauer $\Delta t$ zeitlich verschoben sind.

Im darauffolgenden Verfahrensschritt S50 werden die ZF-gefilterten Signal-Komponenten $x_{InZF1}(t)'$ und $x_{InZF2}(t)'$, die auf das Anregungssignal $x_{In}(t)$ zurückgehen, nach ihrer Digitalisierung in den A/D-Wandlern 6 und 7 gemäß Gleichung (4) und (8) in den digitalen Mischern 9 und 13 ins Basisband gemischt, wobei die zum Anregungssignal $x_{In}(t)$ gehörigen Basisbandsignalkomponenten $x_{InBB1}(t)$ und $x_{InBB2}(t)$ in jedem Umschaltzyklus gegenüber den zum Antwortsignal $x_{Out}(t)$ gehörigen Basisbandsignalkomponenten $x_{OutBB1}(t)$ und $x_{OutBB2}(t)$ um die Umschaltdauer $\Delta t$ zeitlich verschoben ist. Durch Basisbandfilterung der in Fig. 1 nicht dargestellten Bandpassfiltern werden gemäß Gleichung (5) und (9) einzig die Signal-Komponenten $x_{InBB1}(t)'$ und $x_{InBB2}(t)'$ bei der Frequenz Null - Signal-Komponenten am unteren Seitenband der erzeugten Mischerprodukte - weiterverfolgt, wobei die zum Anregungssignal $x_{In}(t)$ gehörigen und nach der Basisbandfilterung weiterverfolgten Basisbandsignalkomponenten $x_{InBB1}(t)'$ und $x_{InBB2}(t)'$ in jedem Umschaltzyklus gegenüber den zum Antwortsignal $x_{Out}(t)$ gehörigen und nach der Basisbandfilterung weiterverfolgten Basisbandsignalkomponenten $x_{OutBB1}(t)'$ und $x_{OutBB2}(t)'$ um die Umschaltdauer $\Delta t$ zeitlich verschoben sind.

Äquivalent werden die ZF-gefilterten Signal-Komponenten $x_{OutBB1}(t)'$ und $x_{OutBB2}(t)'$ die auf das Antwortsignal $x_{Out}(t)$ zurückgehen, nach ihrer Digitalisierung in den A/D-Wandlern 26 und 30 gemäß Gleichung (22) und (24) ins Basisband gemischt, wobei die zum Anregungssignal $x_{Out}(t)$ gehörigen Basisbandsignalkomponenten $x_{OutBB1}(t)$ und $x_{OutBB2}(t)$ in jedem Umschaltzyklus gegenüber den zum Antwortsignal $x_{In}(t)$ gehörigen Basisbandsignalkomponenten $x_{InBB1}(t)$ und $x_{InBB2}(t)$ gemäß Gleichung (22") und (24") um die Umschaltdauer $\Delta t$ zeitlich verschoben ist.

Durch Basisbandfilterung der in Fig. 1A, 1C, 1D und 1E nicht dargestellten Bandpassfiltern werden gemäß Gleichung (23) und (25) einzig die Teilsignale $x_{OutBB1}(t)'$ und $x_{OutBB2}(t)'$ bei der Frequenz Null - Signal-Komponenten am unteren Seitenband der erzeugten Mischerprodukte - weiterverfolgt, wobei die zum Anregungssignal $x_{Out}(t)$ gehörigen und nach der Basisbandfilterung weiterverfolgten Basisbandsignalkomponenten $x_{OutBB1}(t)'$ und $x_{OutBB2}(t)'$ in jedem Umschaltzyklus gegenüber den zum Antwortsignal $x_{In}(t)$ gehörigen und nach der Basisbandfilterung weiterverfolgten Basisbandsignalkomponenten $x_{InBB1}(t)'$ und $x_{InBB2}(t)'$ gemäß Gleichung (23") und (25") um die Umschaltdauer $\Delta t$ zeitlich

verschoben ist.

Im darauffolgenden Verfahrensschritt S60 werden die Phasen $\arg\{x_{InBB1}(t)'\}$ bzw. $\arg\{x_{InBB2}(t)'\}$ der Signal-Komponenten $x_{InBB1}(t)'$ und $x_{InBB2}(t)'$ des auf das Anregungssignal $x_{In}(t)$ zurückgehenden Basisbandsignals bei der Frequenz Null gemäß Gleichung (10) und (11) in den Detektor-Einheiten 14 und 15 und die Phasen $\arg\{x_{OutBB1}(t)'\}$ bzw. $\arg\{x_{OutBB2}(t)'\}$ der Signal-Komponenten $x_{OutBB1}(t)'$ und $x_{OutBB2}(t)'$ des auf das Antwortsignal $x_{Out}(t)$ zurückgehenden Basisbandsignals bei der Frequenz Null gemäß Gleichung (26) und (27) in den Detektor-Einheiten 33 und 34 ermittelt.

In der ersten Ausführungsform des erfindungsgemäßen Systems erfolgt die Detektion der Phasen $\arg\{x_{InBB1}(t)'\}$ bzw. $\arg\{x_{InBB2}(t)'\}$ der Signal-Komponenten $x_{InBB1}(t)'$ und $x_{InBB2}(t)'$ des auf das Anregungssignal $x_{In}(t)$ und der Phasen $\arg\{x_{OutBB1}(t)'\}$ bzw. $\arg\{x_{OutBB2}(t)'\}$ der Signal-Komponenten $x_{OutBB1}(t)'$ und $x_{OutBB2}(t)'$ des Antwortsignals $x_{Out}(t)$ synchron zum Zeitpunkt $t_0$. In der dritten, vierten und fünften Ausführungsform des erfindungsgemäßen Systems werden die Phasen $\arg\{x_{InBB1}(t)'\}$ bzw. $\arg\{x_{InBB2}(t)'\}$ der auf das Anregungssignal $x_{In}(t)$ zurückgehenden Basisbandsignal-Komponenten $x_{InBB1}(t)'$ und $x_{InBB2}(t)'$ synchron zu einem Zeitpunkt $t_0$ und die Phasen $\arg\{x_{OutBB1}(t)'\}$ bzw. $\arg\{x_{OutBB2}(t)'\}$ der auf das Antwortsignal $x_{Out}(t)$ zurückgehenden Basisbandsignal-Komponenten $x_{OutBB1}(t)'$ und $x_{OutBB2}(t)'$ synchron zu einem Zeitpunkt $t_0+\Delta t$ detektiert.

Im abschließenden Verfahrensschritt S70 erfolgt in einer Berechnungseinheit 35 des Netzwerkanalysators gemäß Gleichung (30) die Berechnung der Gruppenlaufzeit $\tau_G$, die vom zu vermessenden Messobjekt 17 verursacht wird, aus der Differenz der Phasendifferenzen $\Delta\varphi_{In}$ und $\Delta\varphi_{Out}$, die gemäß Gleichung (28) aus den Phasen $\arg\{x_{InBB1}(t_0)'\}$ bzw. $\arg\{x_{InBB2}(t_0)'\}$ der Signal-Komponenten $x_{InBB1}(t)'$ und $x_{InBB2}(t)'$ des auf das Anregungssignal $x_{In}(t)$ zurückgehenden Basisbandsignals und gemäß Gleichung (29) aus den Phasen $\arg\{x_{OutBB1}(t_0)'\}$ bzw. $\arg\{x_{OutBB2}(t_0)'\}$ der Signal-Komponenten $x_{OutBB1}(t)'$ und $x_{OutBB2}(t)'$ des auf das Antwortsignal $x_{Out}(t)$ zurückgehenden Basisbandsignals im Fall der ersten Ausführungsform des erfindungsgemäßen Systems und aus den Phasen $\arg\{x_{OutBB1}(t_0+\Delta t)'\}$ bzw. $\arg\{x_{OutBB2}(t_0+\Delta t)'\}$ der Signal-Komponenten $x_{OutBB1}(t)'$ und $x_{OutBB2}(t)'$ des auf das Antwortsignal $x_{Out}(t)$ zurückgehenden Basisbandsignals im Fall der dritten, vierten und fünften Ausführungsform des erfindungsgemäßen Systems ermittelt werden, und mittels anschließender Normierung mit dem Frequenzabstand $\Delta\omega$ des Zweitonsignals.

Im Folgenden wird die zweite Ausführungsform des erfindungsgemäßen Verfahrens zur Messung der Gruppenlaufzeit $\tau_G$ in einem Messobjekt mit einem Netzwerkanalysator für die zweite und sechste Ausführungsform des erfindungsgemäßen Systems anhand des Flussdiagramms in Fig. 2B beschrieben:
Die ersten drei Verfahrensschritte S100, S110 und S120 in der zweiten Ausführungsform entsprechen den ersten drei Verfahrensschritten S10, S20 und S30 in der ersten, Ausführungsform. In Verfahrensschritt S120 werden lediglich die zum Anregungssignal $x_{In}(t)$ gehörigen Zwischenfrequenz- bzw. Basisbandsignale $x_{InDown1}(t)$ und $x_{InDown2}(t)$ gemäß Gleichung (3') und (7') und die zum Antwortsignal $x_{Out}(t)$ gehörigen Zwischenfrequenz- und Basisbandsignale $x_{OutDown1}(t)$ und $x_{OutDown2}(t)$ gemäß Gleichung (19') und (21') ermittelt. In der zweiten Ausführungsform des erfindungsgemäßen Systems erfolgt die Mischung der zum Anregungssignal $x_{In}(t)$ gehörigen hochfrequenten Signalkomponenten $x_{InHF1}(t)$ und $x_{InHF2}(t)$ und der zum Antwortsignal $x_{Out}(t)$ gehörigen hochfrequenten Signale $x_{OutHF1}(t)$ und $x_{OutHF2}(t)$ ins Zwischenfrequenz- bzw. Basisband in einem zum Referenzkanal 22' gehörigen Mischer 4, während die Mischung der zum Antwortsignal $x_{Out}(t)$ gehörigen hochfrequenten Signale $x_{OutHF1}(t)$ und $x_{OutHF2}(t)$ in einem zum Messkanal 21' gehörigen Mischer 23 erfolgt.

In der sechsten Ausführungsform des erfindungsgemäßen Systems erfolgt die Mischung der zum Anregungssignal $x_{In}(t)$ gehörigen Zwischenfrequenz- bzw. Basisbandsignale $x_{InDown1}(t)$ und $x_{InDown2}(t)$ und der zum Antwortsignal $x_{Out}(t)$ gehörigen hochfrequenten Signale $x_{OutHF1}(t)$ und $x_{OutHF2}(t)$ in einem Mischer 4 des gemeinsamen Messkanals 22'''', wobei die zyklische Zuschaltung der zum Anregungssignal $x_{In}(t)$ gehörigen Zwischenfrequenz- bzw. Basisbandsignale $x_{InDown1}(t)$ und $x_{InDown2}(t)$ und der zum Antwortsignal $x_{Out}(t)$ gehörigen hochfrequenten Signale $x_{OutHF1}(t)$ und $x_{OutHF2}(t)$ auf den gemeinsamen Messkanal 22'''' durch einen von einer Empfänger-Steuerung 45 gesteuerten Schalter 44 mit der Umschaltdauer $\Delta t$ erfolgt.

Im nächsten Verfahrensschritt S130 erfolgt die Analog-Digital-Wandlung der zum Anregungssignal $x_{In}(t)$ gehörigen Zwischenfrequenz- bzw. Basisbandsignale $x_{InDown1}(t)$ und $x_{InDown2}(t)$ in einem Analog-Digital-Wandler 37 und der zum Antwortsignal $x_{Out}(t)$ gehörigen Zwischenfrequenz- bzw. Basisbandsignale $x_{OutDown1}(t)$ und $x_{OutDown2}(t)$ in einem Analog-Digital-Wandler 39 im Fall der zweiten Ausführungsform des erfindungsgemäßen Systems und die Analog-Digital-Wandlung der zum Anregungssignal $x_{In}(t)$ gehörigen Zwischenfrequenz- bzw. Basisbandsignale $x_{InDown1}(t)$ und $x_{InDown2}(t)$ und der zum Antwortsignal $x_{Out}(t)$ gehörigen Zwischenfrequenz- bzw. Basisbandsignale $x_{OutDown1}(t)$ und $x_{OutDown2}(t)$ im gemeinsamen Analog-Digital-Wandler 37 im Fall der sechsten Ausführungsform des erfindungsgemäßen Systems.

Anschließend erfolgt die Fast-Fourier-Transformation des zum Anregungssignal $x_{In}(t)$ gehörigen Zwischenfrequenz- bzw. Basisbandsignale $x_{InDown1}(t)$ und $x_{InDown2}(t)$ in einem Fourier-Transformator 38 des Referenzkanals 22' und der zum Antwortsignal $x_{Out}(t)$ gehörigen Zwischenfrequenz- bzw. Basisbandsignale $x_{OutDown1}(t)$ und $x_{OutDown2}(t)$ in einem Fourier-Transformator 40 des Messkanals 21' im Fall der zweiten Ausführungsform des erfindungsgemäßen Systems. Im Fall der sechsten Ausführungsform des erfindungsgemäßen Systems erfolgt die Fast-Fourier-Transformation der zum Anregungssignal $x_{In}(t)$ gehörigen Zwischenfrequenz- bzw. Basisbandsignale $x_{InDown1}(t)$ und $x_{InDown2}(t)$ und

der zum Antwortsignal $x_{Out}(t)$ gehörigen Zwischenfrequenz- bzw. Basisbandsignale $x_{OutDown1}(t)$ und $x_{OutDown2}(t)$ im gemeinsamen Fourier-Transformator 38 des Messkanals 22''''.

Im darauffolgenden Verfahrensschritt S140 werden im Fall der zweiten Ausführungsform des erfindungsgemäßen Systems die Phasen $\arg\{x_{InDown1}(t_0)\}$ und $\arg\{x_{InDown2}(t_0)\}$ der komplexen Spektrallinien der beiden zum Anregungssignal $x_{In}(t)$ gehörigen Zwischenfrequenz- bzw. Basisbandsignale $x_{InDown1}(t)$ und $x_{InDown2}(t)$ gemäß Gleichung (10') und (11') synchron zum Zeitpunkt $t_0$ und die Phasen $\arg\{x_{OutDown1}(t_0)\}$ und $\arg\{x_{OutDown2}(t_0)\}$ der komplexen Spektrallinien der beiden zum Antwortsignal $x_{Out}(t)$ Zwischenfrequenz- bzw. Basisbandsignale $x_{OutDown1}(t)$ und $x_{OutDown2}(t)$ synchron zum Zeitpunkt $t_0$ gemäß Gleichung (26') und (27') bestimmt. Im Fall der sechsten Ausführungsform des erfindungsgemäßen Systems werden die Phasen $\arg\{x_{InDown1}(t_0)\}$ und $\arg\{x_{InDown2}(t_0)\}$ der komplexen Spektrallinien der beiden zum Anregungssignal $x_{In}(t)$ gehörigen Zwischenfrequenz- bzw. Basisbandsignale $x_{InDown1}(t)$ und $x_{InDown2}(t)$ synchron zu einem Zeitpunkt $t_0$ und die Phasen $\arg\{x_{OutDown1}(t_0+\Delta t)\}$ und $\arg\{x_{OutDown2}(t_0+\Delta t)\}$ der komplexen Spektrallinien der beiden zum Antwortsignal $x_{Out}(t)$ gehörigen Zwischenfrequenz- bzw. Basisbandsignale $x_{OutDown1}(t)$ und $x_{OutDown2}(t)$ synchron zu einem Zeitpunkt $t_0+\Delta t$ bestimmt.

Der abschließende Verfahrensschritt S150, in dem die anregungsseitigen und die antwortseitigen Phasendifferenzen und schließlich die Gruppenlaufzeit $\tau_G$ berechnet werden, entsprechen dem Verfahrensschritt S70 in der ersten Ausführungsform.

Optional kann eine i.a. nicht-lineare Phase $\varphi$ des DUT gemäß Gleichung (32) aus der ermittelten Gruppenlaufzeit $\tau_G$ des DUT berechnet werden. Durch lineare Regression wird eine linearisierte Phase aus der i.a. nicht-linearen Phase $\varphi$ bestimmt. Durch Differenzbildung zwischen der i.a. nicht-linearen Phase $\varphi$ und der zugehörigen linearisierten Phase gewinnt man eine relative Phase $\varphi_R$, die die Ungenauigkeit der i.a. nicht-linearen Phase $\varphi$ aufgrund der unbekannten Integrationskonstante nicht aufweist.

Die Erfindung ist nicht auf die dargestellten Ausführungsformen des erfindungsgemäßen Systems und des erfindungsgemäßen Verfahrens zur Messung der Gruppenlaufzeit eines Messobjekts mithilfe eines Netzwerkanalysators beschränkt. Von der Erfindung ist insbesondere eine Realisierung abgedeckt, bei der das Anregungs- und das Antwortsignal unter Umgehung des Zwischenfrequenzbandes direkt vom Hochfrequenz- ins Basisband gemischt wird. Auch ist der Fall von vier phasenkohärent arbeitenden lokalen Mischern zur Mischung der zum Anregungs- und Antwortsignal jeweils gehörigen Testsignale ins Basisband von der Erfindung mit abgedeckt. Schließlich ist von der Erfindung auch der Fall abgedeckt, dass die beiden hochfrequenten Signale $x_{InHF1}(t)$ und $x_{InHF2}(t)$ hinsichtlich Amplitude und Phase unterschiedlich sind.

**Patentansprüche**

1. Verfahren zur Messung einer Gruppenlaufzeit ($\tau_G$), die von einem zu vermessenden Messobjekt (17) verursacht wird, mithilfe eines Netzwerkanalysators umfassend folgende Verfahrensschritte:

   • Erzeugen eines Anregungssignals ($x_{In}(t)$) mit zwei hochfrequenten Eintonsignalen ($x_{In1}(t),x_{In2}(t)$) mit jeweils einer unterschiedlichen Frequenz, die zueinander einen Frequenzabstand ($\Delta\omega$) aufweisen, im Netzwerkanalysator,
   • Anregen des Messobjekts mit dem Anregungssignal ($x_{In}(t)$) und Messen eines Antwortsignals ($x_{Out}(t)$) bestehend aus zwei Signalen ($x_{Out1}(t),x_{Out2}(t)$), die jeweils durch das Messobjekt (17) gegenüber den Signalen ($x_{In1}(t),x_{In2}(t)$) des Anregungssignal ($x_{In}(t)$) phasenverzerrt sind, durch den Netzwerkanalysator,
   • Ermitteln einer Phasendifferenz ($\Delta\varphi_{In}$) zwischen den zum Anregungssignal ($x_{In}(t)$) gehörigen Signalen ($x_{In1}(t),x_{In2}(t)$) und einer Phasendifferenz ($\Delta\varphi_{Out}$) zwischen den zum Antwortsignal ($x_{Out}(t)$) gehörigen Signalen ($x_{Out1}(t),x_{Out2}(t)$) und
   • Berechnen der Gruppenlaufzeit ($\tau_G$) aus der Phasendifferenz ($\Delta\varphi_{In}$) der zum Anregungssignal ($x_{In}(t)$) gehörigen Signale ($x_{In1}(t),x_{In2}(t)$), der Phasendifferenz ($\Delta\varphi_{Out}$) der zum Antwortsignal ($x_{Out}(t)$) gehörigen Signale ($x_{Out1}(t),x_{Out2}(t)$) und dem Frequenzabstand ($\Delta\omega$),

   wobei das Messobjekt (17) eine frequenzumsetzende Funktionseinheit ist,
   wobei die zum Anregungssignal ($x_{In}(t)$) gehörigen Signalen ($x_{In1}(t),x_{In2}(t)$) sequentiell zu den zum Antwortsignal ($x_{Out}(t)$) gehörigen Signale ($x_{Out1}(t),x_{Out2}(t)$) ins Zwischenfrequenzband und/oder ins Basisband gemischt werden.

2. Verfahren nach Anspruch 1,
   **dadurch gekennzeichnet,**
   **dass** das Messobjekt (17) ein Mischer mit integriertem Lokaloszillator ist.

3. Verfahren nach Anspruch 2,

**dadurch gekennzeichnet,**
**dass** das Messobjekt (17) mehrere kaskadiert nacheinander angeordnete Mischer umfasst.

4. Verfahren nach einem der Ansprüche 1 bis 3,
**dadurch gekennzeichnet,**
**dass** jedes im Anregungssignal ($x_{In}(t)$) und im Antwortsignal ($x_{Out}(t)$) jeweils enthaltene Signal ($x_{In1}(t)$,$x_{In2}(t)$, $x_{Out1}(t)$,$x_{Out2}(t)$) jeweils ein sinusförmiges, hochfrequentes Signal ($x_{InHF1}(t)$,$x_{InHF2}(t)$, ($x_{OutHF1}(t)$,$x_{OutHF2}(t)$) ist und in ein zugehöriges zwischenfrequentes Seitenbandsignal ($x_{InZF1}(t)$,$x_{InZF2}(t)$, $x_{OutZF1}(t)$,$x_{OutZF2}(t)$) gemischt wird, das jeweils nach einer Filterung in ein zugehöriges Basisbandsignal ($x_{InBB1}(t)$,$x_{InBB22}(t)$,$x_{OutBB1}(t)$,$x_{OutBB2}(t)$) gemischt wird.

5. Verfahren nach Anspruch 4,
**dadurch gekennzeichnet,**
**dass** die Phasen ($\arg\{x_{InBB1}(t)\}$,$\arg\{x_{InBB2}(t)\}$,$\arg\{x_{OutBB1}(t)\}$, $\arg\{x_{OutBB2}(t)\}$) im Anregungssignals ($x_{In}(t)$) und im Antwortsignal ($x_{Out}(t)$) enthaltenen Basisbandsignale ($x_{InBB1}(t)$,$x_{InBB2}(t)$,$x_{OutBB1}(t)$,$x_{OutBB2}(t)$) synchron zum gleichen Zeitpunkt ($t_0$) im Netzwerkanalysator detektiert werden.

6. Verfahren nach Anspruch 4,
**dadurch gekennzeichnet,**
**dass** die Mischung der zum Anregungssignal ($x_{In}(t)$) und zum Antwortsignal ($x_{Out}(t)$) jeweils gehörigen sinusförmigen, hochfrequenten Signale ($x_{InHF1}(t)$,$x_{InHF2}(t)$, $x_{OutHF1}(t)$,$x_{OutHF2}(t)$) in ein zugehöriges zwischenfrequentes Seitenbandsignal ($x_{InZF1}(t)$,$x_{InZF2}(t)$, $x_{OutZF1}(t)$,$x_{OutZF2}(t)$) jeweils abwechselnd durch einen gemeinsamen lokalen Oszillator (5) mit einer Umschaltdauer ($\Delta t$) erfolgt.

7. Verfahren nach Anspruch 6,
**dadurch gekennzeichnet,**
**dass** die Mischung der zum Anregungssignal ($x_{In}(t)$) und zum Antwortsignal ($x_{Out}(t)$) jeweils gehörigen zwischenfrequenten Seitenbandsignale ($x_{InZF1}(t)$,$x_{InZF2}(t)$, $x_{OutZF1}(t)$,$x_{OutZF2}(t)$) in ein zugehöriges Basisbandsignal ($x_{InBB1}(t)$,$x_{InBB2}(t)$,$x_{OutBB1}(t)$,$x_{OutBB2}(t)$) jeweils abwechselnd durch einen gemeinsamen lokalen Oszillator (42,43) mit einer Umschaltdauer ($\Delta t$) erfolgt.

8. Verfahren nach Anspruch 4,
**dadurch gekennzeichnet,**
**dass** die zum Anregungssignal ($x_{In}(t)$) jeweils gehörigen sinusförmigen, hochfrequenten Signale ($x_{InHF1}(t)$,$x_{InHF2}(t)$ und die zum Antwortsignal ($x_{Out}(t)$) jeweils gehörigen sinusförmigen hochfrequenten Signale ($x_{outHF1}(t)$,$x_{OutHF2}(t)$) abwechselnd mit einer Umschaltdauer ($\Delta t$) in einem gemeinsamen Messkanal (22'''') in ein zugehöriges zwischenfrequentes Seitenbandsignal ($x_{InZF1}(t)$,$x_{InZF2}(t)$, $x_{OutZF1}(t)$,$x_{OutZF2}(t)$) und ein zugehöriges Basisbandsignal ($x_{InBB1}(t)$,$x_{InBB2}(t)$,$x_{OutBB1}(t)$,$x_{OutBB2}(t)$) gemischt werden.

9. Verfahren nach einem der Ansprüche 6 bis 8,
**dadurch gekennzeichnet,**
**dass** die Phasen ($\arg\{x_{InBB1}(t)\}$,$\arg\{x_{InBB2}(t)\}$) aller im Anregungssignal ($x_{In}(t)$) enthaltenen Basisbandsignale ($x_{InBB1}(t)$,$x_{InBB2}(t)$) synchron zu einem ersten identischen Zeitpunkt ($t_0$) und die Phasen ($\arg\{x_{OutBB1}(t)\}$, $\arg\{x_{OutBB2}(t)\}$) aller im Antwortsignal ($x_{Out}(t)$) enthaltenen Basisbandsignale ($x_{OutBB1}(t)$,$x_{OutBB2}(t)$) synchron zu einem zweiten identischen Zeitpunkt ($t_0+\Delta t$) im Netzwerkanalysator detektiert werden.

10. Verfahren nach einer der Ansprüche 4 bis 9,
**dadurch gekennzeichnet,**
**dass** die Filterbandbreite der Filterung im Zwischenfrequenzband größer als eine maximale Drift ($\Delta\omega'$) der Oszillatorfrequenz de(s)r im Messobjekt (13) enthaltenen lokalen Oszillator(s)en (19) ist.

11. Verfahren nach einem der Ansprüche 1 bis 3,
**dadurch gekennzeichnet,**
**dass** jedes im Anregungssignal ($x_{In}(t)$) und im Antwortsignal ($x_{Out}(t)$) jeweils enthaltene Signal ($x_{In1}(t)$,$x_{In2}(t)$, $x_{Out1}(t)$,$x_{Out2}(t)$) jeweils ein sinusförmiges, hochfrequentes Signal ($x_{InHF1}(t)$,$x_{InHF2}(t)$, ($x_{OutHF1}(t)$,$x_{OutHF2}(t)$) ist und jeweils in ein Signal ($x_{InDown1}(t)$,$x_{InDown2}(t)$, $x_{OutDown1}(t)$,$x_{OutDown2}(t)$) im Zwischenfrequenz- oder Basisband gemischt wird und Fourier-transformiert wird.

**12.** Verfahren nach Anspruch 11,
**dadurch gekennzeichnet,**
**dass** die Mischung ins Zwischenfrequenz- oder Basisband und die Fourier-Transformation für die im Anregungssignal ($x_{In}(t)$) jeweils enthaltenen Signale ($x_{In1}(t),x_{In2}(t)$) und die im Antwortsignal ($x_{Out}(t)$) jeweils enthaltenen Signale ($x_{Out1}(t),x_{Out2}(t)$) jeweils abwechselnd um die Umschaltdauer ($\Delta t$) versetzt in einem gemeinsamen Messkanal (22'''') erfolgt.

**13.** Verfahren nach einem der Ansprüche 1 bis 12,
**dadurch gekennzeichnet,**
**dass** die beiden Signale ($x_{In1}(t),x_{In2}(t)$) des Anregungssignals ($x_{In}(t)$) jeweils von einer separaten, im Netzwerkanalysator integrierten Signalquelle (1,7) erzeugt und über eine im Netzwerkanalysator integrierte Signalverknüpfungs-Einheit (36) zum Anregungssignal ($x_{In}(t)$) zusammengeführt werden.

**14.** Verfahren nach einem der Ansprüche 1 bis 13,
**dadurch gekennzeichnet,**
**dass** durch zeitliche Integration der ermittelten Gruppenlaufzeit ($\tau_G$) eine Phase ($\varphi$) des zu vermessenden Messobjekts (17) ermittelt wird.

**15.** Verfahren nach Anspruch 14,
**dadurch gekennzeichnet,**
**dass** für die aus der Gruppenlaufzeit ($\tau_G$) ermittelte Phase ($\varphi$) eine linearisierte Phase und aus der Differenz zwischen der aus der Gruppenlaufzeit ($\tau_G$) ermittelten Phase ($\varphi$) und der linearisierten Phase eine relative Phase ($\varphi_R$) bestimmt wird.

**16.** Netzwerkanalysator zur Messung einer Gruppenlaufzeit ($\tau_G$), die von einem zu vermessenden Messobjekt (17) verursacht wird, mit
einer Signalgenerator-Einheit (2) zur Erzeugung eines Anregungssignals ($x_{In}(t)$) mit zwei hochfrequenten Eintonsignalen ($x_{In1}(t),x_{In2}(t)$) mit jeweils einer unterschiedlichen Frequenz, die zueinander einen Frequenzabstand ($\Delta\omega$) aufweisen, einem Signalverteiler (3) zur gleichzeitigen Zuführung des Anregungssignals ($x_{In}(t)$) an einen mit einem Eingang des Messobjekts (17) verbundenen ersten Anschluss (16) des Netzwerkanalysators und an einen Messkanal (22'''';22''''') bzw. an einen Referenzkanal (22;22';22'';22'''),
einem zweiten, mit einem Ausgang des Messobjekts (17) verbundenen Anschluss (20) des Netzwerkanalysators zur Weiterleitung eines am Ausgang des Messobjekts (17) erfassten, zum Anregungssignal ($x_{In}(t)$) gehörigen Antwortsignals ($x_{Out}(t)$) mit zwei Signalen ($x_{Out1}(t),x_{Out2}(t)$) in einen Messkanal (21;21';21''';22'''';22'''''), im Referenz- bzw. Messkanal (21;21';21'';21''',22;22';22'';22''';22'''';22''''') jeweils mindestens eine Mischer-Einheit (4,9,12,23,27,31) zur Mischung der beiden Signale ($x_{Out1}(t),x_{Out2}(t)$) des Anregungssignals ($x_{In}(t)$) und des Antwortsignals ($x_{Out}(t)$) in jeweils ein Zwischenfrequenz- und/oder Basisbandsignal ($x_{InBB1}(t),x_{InBB2}(t),x_{OutBB1}(t),x_{OutBB2}(t)$; $x_{InDown1}(t),x_{InDown2}(t),x_{OutDown1}(t),x_{OutDown2}(t)$), jeweils zwei Detektor-Einheiten (14,15,33,34) oder einen Fourier-Transformator (38,40) zur Erfassung der zum jeweiligen Zwischenfrequenz- oder Basisbandsignal ($x_{InBB1}(t),x_{InBB2}(t),x_{OutBB1}(t),x_{OutBB2}(t)$; $x_{InDown1}(t),x_{InDown2}(t),x_{OutDown1}(t),x_{OutDown2}(t)$) gehörigen Phasen ($\arg\{x_{InBB1}(t)\},\arg\{x_{InBB2}(t)\},\arg\{x_{OutBB1}(t)\},$ $\arg\{x_{OutBB2}(t)\}$; $\arg\{x_{InDown1}(t)\},\arg\{x_{InDown2}(t)\},\arg\{x_{OutDown1}(t)\},\arg\{x_{OutDown1}(t)\}$) und
einer Berechnungs-Einheit (35) zur Berechnung der Gruppenlaufzeit ($\tau_G$) aus den Phasen ($\arg\{x_{InBB1}(t_0)\},\arg\{x_{InBB2}(t_0)\}$, $\arg\{x_{OutBB1}(t_0)\}$, $\arg\{x_{OutBB2}(t_0)\}$; $\arg\{x_{InDown1}(t_0)\},\arg\{x_{InDown2}(t_0)\},\arg\{x_{OutDown1}(t)\},$ $\arg\{x_{OutDown2}(t)\}$) der Zwischenfrequenz- oder Basisbandsignale ($x_{InBB1}(t),x_{InBB2}(t),x_{OutBB1}(t),x_{OutBB2}(t)$; $x_{InDown1}(t),x_{InDown2}(t),x_{OutDown1}(t),x_{OutDown2}(t)$), wobei das Messobjekt (17) eine frequenzumsetzende Funktionseinheit ist,
wobei Schalter (41;41,42,43;44) zur sequentiellen Zuführung der zum Anregungssignal ($x_{In}(t)$) gehörigen Signale ($x_{In1}(t),x_{In2}(t)$) und der zum Antwortsignal ($x_{Out}(t)$) gehörigen Signale ($x_{Out1}(t),x_{Out2}(t)$) an die zugehörige Mischer-Einheit (4,9,12,23,27,31) vorgesehen sind.

**17.** Netzwerkanalysator nach Anspruch 16,
**dadurch gekennzeichnet,**
**dass** die Signalgenerator-Einheit (2) aus zwei Signalquellen (1,7) zur Erzeugung jeweils eines der beiden Signale ($x_{In1}(t),x_{In2}(t)$) des Anregungssignals ($x_{In}(t)$) und einer nachgeschalteten Signalverknüpfungs-Einheit (36) zur Zusammenführung der beiden Signale ($x_{In1}(t),x_{In2}(t)$) zum Anregungssignal ($x_{In}(t)$) besteht.

**18.** Netzwerkanalysator nach Anspruch 17,

**dadurch gekennzeichnet,**
**dass** die Signalverknüpfungs-Einheit (36) ein HochfrequenzKoppler ist.

19. Netzwerkanalysator nach Anspruch 18,
**dadurch gekennzeichnet,**
**dass** die Signalverknüpfungs-Einheit (36) ein Mischer ist.

**Claims**

1. Method for measuring a group delay time ($\tau_G$) caused by a device under test (17), with the aid of a network analyser comprising the following method steps:

   • Generation of an excitation signal ($x_{In}(t)$) with two high frequency single tone signals ($x_{In1}(t),x_{In2}(t)$) each having a different frequency separated by a frequency gap ($\Delta\omega$), in the network analyser,
   • Excitation of the device under test with the excitation signal ($x_{In}(t)$) and measurement of a response signal ($x_{Out}(t)$) consisting of two signals ($x_{Out1}(t),x_{Out2}(t)$) which are each distorted out of phase by the device under test (17) with respect to the signals ($x_{In}(t),x_{In2}(t)$) of the excitation signal ($x_{In}(t)$), by the network analyser,
   • Determination of a phase difference ($\Delta\varphi_{In}$) between the signals ($x_{In1}(t),x_{In2}(t)$) belonging to the excitation signal ($x_{In}(t)$) and of a phase difference ($\Delta\varphi_{Out}$) between the signals ($x_{Out1}(t),x_{Out2}(t)$) belonging to the response signal ($x_{Out}(t)$) and
   • Calculation of the group delay time ($\tau_G$) from the phase difference ($\Delta\varphi_{In}$) of the signals ($x_{In1}(t),x_{In2}(t)$) belonging to the excitation signal ($x_{In}(t)$), the phase difference ($\Delta\varphi_{Out}$) of the signals ($x_{Out1}(t),x_{Out2}(t)$) belonging to the response signal ($x_{Out}(t)$) and the frequency gap ($\Delta\omega$),

   wherein the device under test (17) is a frequency-converting function unit,
   wherein the signals ($x_{In1}(t),x_{In2}(t)$) belonging to the excitation signal ($x_{In}(t)$) are mixed into the intermediate frequency band and/or into the base band sequentially to the signals ($x_{Out1}(t),x_{Out2}(t)$) belonging to the response signal ($x_{Out}(t)$).

2. Method according to claim 1,
   **characterised in that**
   the device under test (17) is a mixer with an integrated local oscillator.

3. Method according to claim 2,
   **characterised in that**
   the device under test (17) comprises a plurality of mixers arranged cascaded one after another.

4. Method according to one of claims 1 to 3,
   **characterised in that**
   each signal ($x_{In1}(t),x_{In2}(t)$), ($x_{Out1}(t),x_{Out2}(t)$)) contained in the excitation signal ($x_{In}(t)$) and in the response signal ($x_{Out}(t)$) is in each case a sinusoidal high frequency signal (($x_{InHF1}(t),x_{InHF2}(t)$, $x_{OutHF1}(t),x_{OutHF2}(t)$) and is mixed into an associated intermediate frequency side band signal ($x_{InZF1}(t),x_{InZF2}(t)$, $x_{OutZF1}(t),x_{OutZF2}(t)$) which after filtering is in each case mixed into an associated base band signal ($x_{InBB1}(t),x_{InBB2}(t),x_{OutBB1}(t),x_{OutBB2}(t)$).

5. Method according to claim 4,
   **characterised in that**
   the phases ($\arg\{x_{InBB1}(t)\}$, $\arg\{x_{InBB2}(t)\}$, $\arg\{x_{OutBB1}(t)\}$, $\arg\{x_{OutBB2}(t)\}$) of base band signals ($x_{InBB1}(t),x_{InBB2}(t),x_{OutBB1}(t),x_{OutBB2}(t)$) contained in the excitation signal ($x_{In}(t)$) and in the response signal ($x_{Out}(t)$) are detected synchronously at the same point in time ($t_0$) in the network analyser.

6. Method according to claim 4,
   **characterised in that**
   the mixing of the sinusoidal high frequency signals ($x_{InHF1}(t),x_{InHF2}(t)$, $x_{OutHF1}(t),x_{OutHF2}(t)$) belonging in each case to the excitation signal ($x_{In}(t)$) and to the response signal ($x_{Out}(t)$) into an associated intermediate frequency side band signal ($x_{InZF1}(t),x_{InZF2}(t)$, $x_{OutZF1}(t),x_{OutZF2}(t)$) is in each case carried out alternately by a common local oscillator (5) with a switching time ($\Delta t$).

7. Method according to claim 6,

**characterised in that**

the mixing of the intermediate frequency side band signals ($x_{InZF1}(t),x_{InZF2}(t)$, $x_{OutZF1}(t),x_{OutZF2}(t)$) belonging in each case to the excitation signal ($x_{In}(t)$) and to the response signal ($x_{Out}(t)$) into an associated base band signal ($x_{InBB1}(t),x_{InBB2}(t),x_{OutBB1}(t),x_{OutBB2}(t)$) is in each case carried out alternately by a common local oscillator (42,43) with a switching time ($\Delta t$).

8.  Method according to claim 4,
    **characterised in that**
    the sinusoidal high frequency signals ($x_{InHF1}(t),x_{InHF2}(t)$) belonging in each case to the excitation signal ($x_{In}(t)$) and the sinusoidal high frequency signals ($x_{OutHF1}(t),x_{OutHF2}(t)$) belonging in each case to the response signal ($x_{Out}(t)$) are mixed alternately with a switching time ($\Delta t$) in a common measurement channel (22'''') into an associated intermediate frequency side band signal ($x_{InZF1}(t),x_{InZF2}(t)$, $x_{OutZF1}(t),x_{OutZF2}(t)$) and an associated base band signal ($x_{InBB1}(t),x_{OutBB2}(t),x_{OutBB1}(t),x_{OutBB2}(t)$).

9.  Method according to one of claims 6 to 8,
    **characterised in that**
    the phases ($\arg\{x_{InBB1}(t)\},\arg\{x_{InBB2}(t)\}$) of all the base band signals ($x_{InBB1}(t),x_{InBB2}(t)$) contained in the excitation signal ($x_{In}(t)$) are detected synchronously at a first identical point in time ($t_0$) and the phases ($\arg\{x_{OutBB1}(t)\}$, $\arg\{x_{OutBB2}(t)\}$) of all the base band signals ($x_{OutBB1}(t),x_{OutBB2}(t)$) contained in the response signal ($x_{Out}(t)$) are detected synchronously at a second identical point in time ($t_0+\Delta t$) in the network analyser.

10. Method according to one of claims 4 to 9,
    **characterised in that**
    the filter band width of the filtering in the intermediate frequency band is greater than a maximum drift ($\Delta\omega'$) of the oscillator frequency of the local oscillator or oscillators (19) contained in the device under test (13).

11. Method according to one of claims 1 to 3,
    **characterised in that**
    each signal ($x_{In1}(t),x_{In2}(t)$, $x_{Out1}(t),x_{Out2}(t)$) contained in each case in the excitation signal ($x_{In}(t)$) and in the response signal ($x_{Out}(t)$) is in each case a sinusoidal high frequency signal ($x_{InHF1}(t),x_{InHF2}(t)$, $x_{OutHF1}(t),x_{OutHF2}(t)$) and is in each case mixed into a signal ($x_{InDown1}(t),x_{InDown2}(t)$, $x_{OutDown1}(t)$, $x_{OutDown2}(t)$) in the intermediate frequency band or base band and Fourier transformed.

12. Method according to claim 11,
    **characterised in that**
    the mixing into the intermediate frequency band or base band and the Fourier transformation for the signals ($x_{In1}(t),x_{In2}(t)$) contained in each case in the excitation signal ($x_{In}(t)$) and the signals ($x_{Out1}(t),x_{Out2}(t)$) contained in each case in the response signal ($x_{Out}(t)$) is in each case carried out alternately offset by the switching time ($\Delta t$) in a common measurement channel (22''''').

13. Method according to one of claims 1 to 12,
    **characterised in that**
    the two signals ($x_{In1}(t),x_{In2}(t)$) of the excitation signal ($x_{In}(t)$) are in each case generated by a separate signal source (1, 7) integrated in the network analyser and combined together to form the excitation signal ($x_{In}(t)$) by means of a signal combining unit (36) integrated in the network analyser.

14. Method according to one of claims 1 to 13, **characterised in that**
    a phase ($\varphi$) of the device under test (17) is determined by integration of the determined group delay time ($\tau_G$) with respect to time.

15. Method according to claim 14,
    **characterised in that**
    a linearised phase is established for the phase ($\varphi$) determined from the group delay time ($\tau_G$) and a relative phase ($\varphi_R$) is established from the difference between the phase ($\varphi$) determined from the group delay time ($\tau_G$) and the linearised phase.

16. Network analyser for measuring a group delay time ($\tau_G$) caused by a device under test (17), with a signal generator unit (2) for generation of an excitation signal ($x_{In}(t)$) with two high frequency single tone signals

$(x_{In1}(t), x_{In2}(t))$ each having a different frequency separated by a frequency gap $(\Delta\omega)$,
a signal divider (3) for simultaneous feeding of the excitation signal $(x_{In}(t))$ to a first terminal (16) of the network analyser connected with one input of the device under test (17) and to a measurement channel (22'''';22''''') or to a reference channel (22;22';22'';22'''),
a second terminal (20) of the network analyser connected with one output of the device under test (17) for feeding a response signal $(x_{Out}(t))$ with two signals $(x_{Out1}(t), x_{Out2}(t))$ belonging to the excitation signal $(x_{In}(t))$ and detected at the output of the device under test (17) on into a measurement channel (21;21';21'';21''';22'''';22'''''), in the reference or measurement channel (21;21';21'';21''',22;22';22'';22''';22'''';22''''') in each case at least one mixer unit (4,9,12,23,27,31) for mixing the two signals $(x_{Out1}(t), x_{Out2}(t))$ of the excitation signal $(x_{In}(t))$ and the response signal $(x_{Out}(t))$ into in each case an intermediate frequency band and/or base band signal $(x_{InBB1}(t), x_{InBB2}(t), x_{OuBB1}(t), x_{OutBB2}(t); x_{InDown1}(t), x_{InDown2}(t), x_{OutDown1}(t), x_{OutDown2}(t))$,
in each case two detector units (14,15,33,34) or a Fourier transformer (38,40) for detection of the phases $(\arg\{x_{InBB1}(t)\}, \arg\{x_{InBB2}(t)\}, \arg\{x_{OutBB1}(t)\}, \arg\{x_{OutBB2}(t)\}$; $\arg\{x_{InDown1}(t)\}, \arg\{x_{InDown2}(t)\}, \arg\{x_{OutDown1}(t)\}, \arg\{x_{OutDown2}(t)\})$ belonging to the respective intermediate frequency band or base band signal $(x_{InBB1}(t), x_{InBB2}(t), x_{OutBB1}(t), x_{OutBB2}(t); x_{InDown1}(t), x_{InDown2}(t), x_{OutDown1}(t), x_{OutDown2}(t))$, and
a calculating unit (35) for calculation of the group delay time $(\tau_G)$ from the phases $(\arg\{x_{InBB1}(t_0)\}, \arg\{x_{InBB2}(t_0)\}, \arg\{x_{OutBB1}(t_0)\}, \arg\{x_{OutBB2}(t_0)\}$; $\arg\{x_{InDown1}(t)\}, \arg\{x_{InDown2}(t)\}, \arg\{x_{OutDown1}(t)\}, \arg\{x_{OutDown2}(t)\})$ of the intermediate frequency band or base band signals $(x_{InBB1}(t), x_{InBB2}(t), x_{OutBB1}(t), x_{OutBB2}(t); x_{InDown1}(t), x_{InDown2}(t), x_{OutDown1}(t), x_{OutDown2}(t))$,
wherein the device under test (17) is a frequency-converting function unit,
wherein switches (41;41,42,43;44) are provided for sequential feeding of the signals $(x_{In1}(t), x_{In2}(t))$ belonging to the excitation signal $(x_{In}(t))$ and the signals $(x_{Out1}(t), x_{Out2}(t))$ belonging to the response signal $(x_{Out}(t))$ to the associated mixer unit (4,9,12,23,27,31).

17. Network analyser according to claim 16,
**characterised in that**
the signal generator unit (2) comprises two signal sources (1,7) for generation of in each case one of the two signals $(x_{In1}(t), x_{In2}(t))$ of the excitation signal $(x_{In}(t))$ and a following signal combining unit (36) for combining together the two signals $(x_{In1}(t), x_{In2}(t))$ to form the excitation signal $(x_{In}(t))$.

18. Network analyser according to claim 17,
**characterised in that**
the signal combining unit (36) is a high frequency coupler.

19. Network analyser according to claim 18,
**characterised in that**
the signal combining unit (36) is a mixer.

**Revendications**

1. Procédé de mesure d'un temps de propagation de groupe $(\tau_G)$, qui est provoqué par un objet à mesurer (17), à l'aide d'un analyseur de réseau, le procédé comportant les étapes suivantes :

   • la production d'un signal d'excitation $(x_{In}(t))$ comprenant deux signaux monotones haute fréquence $(x_{In1}(t), (x_{In2}(t))$ présentant chacun une fréquence différente, qui présentent l'un par rapport à l'autre un écart de fréquences $(\Delta\omega)$, dans l'analyseur de réseau,
   • l'excitation de l'objet à mesurer au moyen du signal d'excitation $(x_{In}(t))$ et la mesure d'un signal de réponse $(x_{Out}(t))$ constitué de deux signaux $(x_{Out1}(t), (x_{Out2}(t))$, qui sont respectivement distordus en phase à travers l'objet à mesurer (17) par rapport aux signaux $(x_{In1}(t), (x_{In2}(t))$ du signal d'excitation $(x_{In}(t)$, par l'analyseur de réseau,
   • la détermination d'une différence de phase $(\Delta\varphi_{In})$ entre les signaux $(x_{In1}(t), (x_{In2}(t))$ appartenant au signal d'excitation $(x_{In}(t))$ et d'une différence de phase $(\Delta\varphi_{Out})$ entre les signaux $(x_{Out1}(t), (x_{Out2}(t))$ appartenant au signal de réponse $(x_{Out}(t))$ et
   • le calcul du temps de propagation de groupe $(\tau_G)$ à partir de la différence de phase $(\Delta\varphi_{In})$ des signaux $(x_{In1}(t), (x_{In2}(t))$ appartenant au signal d'excitation $(x_{In}(t))$, de la différence de phase $(\Delta\varphi_{Out})$ des signaux $(x_{Out1}(t), (x_{Out2}(t))$ appartenant au signal de réponse $(x_{Out}(t))$ et de l'écart de fréquences $(\Delta\omega)$,

dans lequel l'objet à mesurer (17) est une unité fonctionnelle à conversion de fréquence,
dans lequel les signaux ($x_{In1}(t),(x_{In2}(t)$) appartenant au signal d'excitation ($x_{In}(t)$) sont mélangés de manière séquentielle aux signaux ($x_{Out1}(t),(x_{Out2}(t)$) appartenant au signal de réponse ($x_{Out}(t)$) dans la bande de fréquences intermédiaire et/ou dans la bande de base.

2. Procédé selon la revendication 1,
**caractérisé**
**en ce que** l'objet à mesurer (17) est un mélangeur comprenant un oscillateur local intégré.

3. Procédé selon la revendication 2,
**caractérisé**
**en ce que** l'objet à mesurer (17) comporte plusieurs mélangeurs agencés les uns derrière les autres en cascade.

4. Procédé selon l'une quelconque des revendications 1 à 3,
**caractérisé**
**en ce que** chaque signal ($x_{In1}(t),x_{In2}(t),x_{Out1}(t),x_{Out2}(t)$) respectivement contenu dans le signal d'excitation ($x_{In}(t)$) et dans le signal de réponse ($x_{Out}(t)$) est dans chaque cas un signal sinusoïdal haute fréquence ($x_{InHF1}(t),x_{InHF2}(t),x_{OutHF1}(t),x_{OutHF2}(t)$) et est mélangé dans un signal de bande latérale de fréquence intermédiaire ($x_{InZF1}(t),x_{InZF2}(t),x_{OutZF1}(t)x_{OutZF2}(t)$) associé, qui est mélangé dans chaque cas après un filtrage dans un signal de bande de base ($x_{InBB1}(t),x_{InBB2}(t),x_{OutBB1}(t),x_{OutBB2}(t)$) associé.

5. Procédé selon la revendication 4,
**caractérisé**
**en ce que** les phases (arg$\{x_{InBB1}(t)\}$,arg$\{x_{InBB2}(t)\}$,arg$\{x_{OutBB1}(t)\}$,arg$\{x_{OutBB2}(t)\}$) des signaux de bande de base ($x_{InBB1}(t),x_{InBB2}(t),x_{OutBB1}(t),x_{OutBB2}(t)$) contenus dans le signal d'excitation ($x_{In}(t)$) et dans le signal de réponse ($x_{Out}(t)$) sont détectés de manière synchrone au même moment ($t_0$) dans l'analyseur de réseau.

6. Procédé selon la revendication 4,
**caractérisé**
**en ce que** le mélange des signaux sinusoïdaux haute fréquence ($x_{InHF1}(t), x_{InHF2}(t), x_{OutHF1}(t), x_{OutHF2}(t)$) appartenant respectivement au signal d'excitation ($x_{In}(t)$) et au signal de réponse ($x_{Out}(t)$) s'effectue dans un signal de bande latérale de fréquence intermédiaire ($x_{InZF1}(t),x_{InZF2}(t),x_{OutZF1}(t),x_{OutZF2}(t)$) associé respectivement en alternance par l'intermédiaire d'un oscillateur local (5) commun pendant une durée de commutation ($\Delta t$).

7. Procédé selon la revendication 6,
**caractérisé**
**en ce que** le mélange des signaux de bande latérale de fréquence intermédiaire ($x_{InZF1}(t),x_{InZF2}(t),x_{OutZF1}(t),x_{OutZF2}(t)$) appartenant respectivement au signal d'excitation ($x_{In}(t)$) et au signal de réponse ($x_{Out}(t)$) s'effectue dans un signal de bande de base ($x_{InBB1}(t),x_{InBB2}(t),x_{OutBB1}(t),x_{OutBB2}(t)$) associé respectivement en alternance par l'intermédiaire d'un oscillateur local (42, 43) commun pendant une durée de commutation ($\Delta t$).

8. Procédé selon la revendication 4,
**caractérisé**
**en ce que** les signaux sinusoïdaux haute fréquence ($x_{InHF1}(t),x_{InHF2}(t)$) appartenant respectivement au signal d'excitation ($x_{In}(t)$) et les signaux sinusoïdaux haute fréquence ($x_{OutHF1}(t),x_{OutHF2}(t)$) appartenant respectivement au signal de réponse ($x_{Out}(t)$) sont mélangés en alternance pendant une durée de commutation ($\Delta t$) dans un canal de mesure (22'''') commun dans un signal de bande de base à fréquence intermédiaire ($x_{InZF1}(t),x_{InZF2}(t),x_{OutZF1}(t),x_{OutZF2}(t)$) associé et un signal de bande de base ($x_{InBB1}(t),x_{InBB2}(t),x_{OutBB1}(t),x_{OutBB2}(t)$) associé.

9. Procédé selon l'une quelconque des revendications 6 à 8,
**caractérisé**
**en ce que** les phases (arg$\{x_{InBB1}(t)\}$,arg$\{x_{InBB2}(t)\}$) de tous les signaux de bande de base ($x_{InBB1}(t),x_{InBB2}(t)$) contenus dans le signal d'excitation ($x_{In}(t)$) sont détectées de manière synchrone à un premier moment ($t_0$) identique et les phases (arg$\{x_{OutBB1}(t)\}$,arg$\{x_{OutBB2}(t)\}$) de tous les signaux de bande de base ($x_{OutBB1}(t),x_{OutBB2}(t)$) contenus dans le signal de réponse ($x_{Out}(t)$) sont détectées de manière synchrone dans l'analyseur de réseau à un deuxième même moment identique ($t_0+\Delta t$).

**10.** Procédé selon l'une quelconque des revendications 4 à 9, **caractérisé en ce que** la largeur de bande de filtre de la filtration dans la bande de fréquences intermédiaire est supérieure à une dérive maximale ($\Delta\omega'$) de la fréquence d'oscillateur de l'oscillateur local (des oscillateurs locaux) (19) commun(s) contenu(s) dans l'objet à mesurer (13).

**11.** Procédé selon l'une quelconque des revendications 1 à 3, **caractérisé en ce que** chaque signal ($x_{In1}(t), x_{In2}(t), x_{Out1}(t), x_{Out2}(t)$) respectivement contenu dans le signal d'excitation ($x_{In}(t)$) et dans le signal de réponse ($x_{Out}(t)$) est dans chaque cas un signal sinusoïdal haute fréquence ($x_{InHF1}(t), x_{InHF2}(t), x_{OutHF1}(t), x_{OutHF2}(t)$) et est mélangé respectivement dans un signal ($x_{InDown1}(t), x_{InDown2}(t), x_{OutDown1}(t), x_{OutDown2}(t)$) dans la bande de fréquences intermédiaire ou de base et est soumise à une transformée de Fourier.

**12.** Procédé selon la revendication 11, **caractérisé en ce que** le mélange dans la bande de fréquences intermédiaire ou de base et la transformée de Fourier pour les signaux ($x_{In1}(t), x_{In2}(t)$) respectivement contenus dans le signal d'excitation ($x_{In}(t)$) et les signaux ($x_{Out1}(t), x_{Out2}(t)$) respectivement contenus dans le signal de réponse ($x_{Out}(t)$) s'effectue respectivement en alternance en étant décalés de la durée de commutation ($\Delta t$) dans un canal de mesure (22"") commun.

**13.** Procédé selon l'une quelconque des revendications 1 à 12, **caractérisé en ce que** les deux signaux ($x_{In1}(t), x_{In2}(t)$) du signal d'excitation ($x_{In}(t)$) sont produits respectivement par une source de signaux (1, 7) séparée intégrée dans l'analyseur de réseau, et sont réunis par l'intermédiaire d'une unité de combinaison de signaux (36) intégrée dans l'analyseur de réseau de manière à obtenir le signal d'excitation ($x_{In}(t)$).

**14.** Procédé selon l'une quelconque des revendications 1 à 13, **caractérisé en ce qu'**une phase ($\varphi$) de l'objet à mesurer (17) est déterminée par intégration temporelle du temps de propagation de groupe ($\tau_G$) déterminé.

**15.** Procédé selon la revendication 14, **caractérisé en ce que** pour la phase ($\varphi$) déterminée à partir du temps de propagation de groupe ($\tau_G$), une phase linéarisée est définie et une phase relative ($\varphi_R$) est définie à partir de la différence entre la phase ($\varphi$) déterminée à partir du temps de propagation de groupe ($\tau_G$) et la phase linéarisée.

**16.** Analyseur de réseau destiné à mesurer un temps de propagation de groupe ($\tau_G$) qui est provoqué par un objet à mesurer (17), comprenant une unité de génération de signal (2) destinée à produire un signal d'excitation ($x_{In}(t)$) comprenant deux signaux monotones haute fréquence ($x_{In1}(t), x_{In2}(t)$) présentant chacun une fréquence différente, qui présentent l'un par rapport à l'autre un écart de fréquences ($\Delta\omega$), un répartiteur de signaux (3) pour l'amenée simultanée du signal d'excitation ($x_{In}(t)$) à une première connexion (16) de l'analyseur de réseau reliée à une entrée de l'objet à mesurer (17) et à un canal de mesure (22"" ; 22""") ou à un canal de référence (22 ; 22' ; 22" ; 22"'), une deuxième connexion (20) de l'analyseur de réseau reliée à une sortie de l'objet à mesurer (17) pour la transmission d'un signal de réponse ($x_{Out}(t)$) détecté à la sortie de l'objet à mesurer (17) et appartenant au signal d'excitation ($x_{In}(t)$) et présentant deux signaux ($x_{Out1}(t), x_{Out2}(t)$) dans un canal de mesure (21 ; 21' ; 21" ; 21"' ; 22"" ; 22""'), dans le canal de référence ou de mesure (21 ; 21' ; 21" ; 21"' ; 22 ; 22' ; 22" ; 22"' ; 22"" ; 22""') à respectivement au moins une unité mélangeuse (4, 9, 12, 23, 27, 31) destinée à mélanger les deux signaux ($X_{Out1}(t), x_{Out2}(t)$) du signal d'excitation ($x_{In}(t)$) et du signal de réponse ($x_{Out}(t)$) dans respectivement un signal de bande de fréquences intermédiaire et/ou de base ($x_{InBB1}(t), x_{InBB2}(t), x_{OutBB1}(t), x_{OutBB2}(t); x_{InDown1}(t), x_{InDown2}(t), x_{OutDown1}(t), x_{OutDown2}(t)$), respectivement deux unités de détection (14, 15, 33, 34) ou un transformateur de Fourier (38, 40) destiné à détecter les phases ($\arg\{x_{InBB1}(t)\}, \arg\{x_{InBB2}(t)\}, arg\{x_{OutBB1}(t)\}, \arg\{x_{OutBB2}(t)\}; \arg\{x_{InDown1}(t)\}, \arg\{x_{InDown2}(t)\}, \arg\{x_{OutDown1}(t)\}, \arg\{x_{OutDown2}(t)\}$) appartenant au signal respectif de bande de fréquences intermédiaire et/ou de base ($x_{InBB1}(t), x_{InBB2}(t), x_{OutBB1}(t), x_{OutBB2}(t); x_{InDown1}(t), x_{InDown2}(t), x_{OutDown1}(t), x_{OutDown2}(t)$) et une unité de calcul (35) destinée à calculer le temps de propagation de groupe ($\tau_G$) à partir des phases

$(\arg\{x_{InBB1}(t)\}, \arg\{x_{InBB2}(t)\}, \arg\{x_{OutBB1}(t)\}, \arg\{x_{OutBB2}(t)\}$ ;
$\arg\{x_{InDown1}(t)\}, \arg\{x_{InDown2}(t)\}, \arg\{x_{OutDown1}(t)\}, \arg\{x_{OutDown2}(t)\})$ des signaux de bande de fréquences intermédiaire ou de base $(x_{InBB1}(t), x_{InBB2}(t), x_{OutBB1}(t), x_{OutBB2}(t)$ ; $x_{InDown1}(t), x_{InDown2}(t), x_{OutDown1}(t), x_{OutDown2}(t))$, dans lequel l'objet à mesurer (17) est une unité fonctionnelle à conversion de fréquence, dans lequel des commutateurs (41 ; 41, 42, 43 ; 44) sont destinés à l'amenée séquentielle des signaux $(x_{In1}(t), x_{In2}(t)$ appartenant au signal d'excitation $(x_{In}(t))$ et des signaux $(x_{Out1}(t), x_{Out2}(t))$ appartenant au signal de réponse $(x_{Out}(t))$ à l'unité mélangeuse (4, 9, 12, 23, 27, 31) associée.

**17.** Analyseur de réseau selon la revendication 16,
**caractérisé**
**en ce que** l'unité de génération de signaux (2) est constituée de deux sources de signaux (1, 7) destinées à produire respectivement l'un des deux signaux $(x_{In1}(t), x_{In2}(t))$ du signal d'excitation $(x_{In}(t))$ et d'une unité de combinaison de signaux (36) montée en aval et destinée à réunir les deux signaux $(x_{In1}(t), x_{In2}(t))$ de manière à obtenir le signal d'excitation $(x_{In}(t))$.

**18.** Analyseur de réseau selon la revendication 17,
**caractérisé**
**en ce que** l'unité de combinaison de signaux (36) est un coupleur haute fréquence.

**19.** Analyseur de réseau selon la revendication 18,
**caractérisé**
**en ce que** l'unité de combinaison de signaux (36) est un mélangeur.

Fig. 1A

Fig. 1B

Fig. 1C

EP 2 376 931 B1

Fig. 1D

Fig. 1E

Fig. 1F

```
                          ┌─────────────┐
                          │    Start    │
                          └─────────────┘
                                 │
                                 ▼
  ┌────────────────────────────────────────────────────────────┐
  │          Erzeugen eines als Zweitonsignal                  │──S10
  │             realisierten Anregungssignal                   │
  └────────────────────────────────────────────────────────────┘
                                 │
                                 ▼
  ┌────────────────────────────────────────────────────────────┐
  │     Anregen des Dut mit dem erzeugten Anregungssignal       │──S20
  │         und Erfassen des zugehörigen Antwortsignals         │
  └────────────────────────────────────────────────────────────┘
                                 │
                                 ▼
  ┌────────────────────────────────────────────────────────────┐
  │      Mischen des Anregungssignal und des Antwortsignals     │
  │    in einem zugehörigen Meß- bzw. Referenzkanal ins         │──S30
  │     Zwischenfrequenzband (gleichzeitig oder parallel)       │
  └────────────────────────────────────────────────────────────┘
                                 │
                                 ▼
  ┌────────────────────────────────────────────────────────────┐
  │   Tiefpass-Filtern jedes zum Anregungs- und Antwortsignal   │──S40
  │  gehörigen Teil-Signals und Digitalisierung mittels A/D-Wandler │
  └────────────────────────────────────────────────────────────┘
                                 │
                                 ▼
  ┌────────────────────────────────────────────────────────────┐
  │     Digitales Mischen jeder ZF-gefilterten Teil-Signale     │──S50
  │     des Anregungs- und Antwortsignals ins Basisband         │
  └────────────────────────────────────────────────────────────┘
                                 │
                                 ▼
  ┌────────────────────────────────────────────────────────────┐
  │       Detektieren der Phasen des zum Anregungs- und         │──S60
  │     Antwortsignals gehörigen Testsignals im Basisband       │
  └────────────────────────────────────────────────────────────┘
                                 │
                                 ▼
  ┌────────────────────────────────────────────────────────────┐
  │   Berechnen der Gruppenlaufzeit des Meßobjekts als Differenz │
  │  der Phasendifferenz der beiden zum Antwortsignal jeweils gehörigen │
  │  Teil-Signale von der Phasendifferenz der beiden zum Anregungs- │──S70
  │  signal jeweils gehörigen Teil-Signale und Normierung der Differenz │
  │       mit dem Frequenzabstand der beiden Teil-Signale       │
  └────────────────────────────────────────────────────────────┘
                                 │
                                 ▼
                          ┌─────────────┐
                          │    Ende     │
                          └─────────────┘
```

# Fig. 2A

```
            ┌─────────────┐
            │    Start    │
            └──────┬──────┘
                   │
                   ▼
   ┌──────────────────────────────────────┐
   │   Erzeugen eines als Zweitonsignal    │──── S100
   │     realisierten Anregungssignal      │
   └──────────────────┬───────────────────┘
                      │
                      ▼
   ┌──────────────────────────────────────┐
   │  Anregen des Dut mit dem erzeugten Anregungssignal  │──── S110
   │    und Erfassen des zugehörigen Antwortsignals       │
   └──────────────────┬───────────────────┘
                      │
                      ▼
   ┌──────────────────────────────────────┐
   │     Mischen des Anregungs- und des Antwortsignals        │
   │   in einem zugehörigen Meß- bzw. Referenzkanal ins       │──── S120
   │  Zwischenfrequenz- bzw. Basisband (gleichzeitig oder parallel) │
   └──────────────────┬───────────────────┘
                      │
                      ▼
   ┌──────────────────────────────────────┐
   │  Analog- Digital- Wandeln und Fast- Fourier- Transformieren  │──── S130
   │   der zugehörigen Zwischenfrequenz- bzw. Basisbandsignale    │
   └──────────────────┬───────────────────┘
                      │
                      ▼
   ┌──────────────────────────────────────┐
   │      Ermitteln der Phasen der Fourier- Transformierten      │──── S140
   │   der zugehörigen Zwischenfrequenz- bzw. Basisbandsignale   │
   └──────────────────┬───────────────────┘
                      │
                      ▼
   ┌──────────────────────────────────────┐
   │   Berechnen der Gruppenlaufzeit des Meßobjekts als Differenz    │
   │  der Phasendifferenz der beiden zum Antwortsignal jeweils gehörigen │
   │ Testsignale von der Phasendifferenz der beiden zum Anregungs-  │──── S150
   │  signal jeweils gehörigen Testsignale und Normieren der Differenz │
   │       mit dem Frequenzabstand der beiden Testsignale          │
   └──────────────────┬───────────────────┘
                      │
                      ▼
            ┌─────────────┐
            │     Ende    │
            └─────────────┘
```

## Fig. 2B

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1515147 A1
- EP 0293883 A1
- US 6046595 A
- US 6529844 B1
- US 20030233599 A1